# EUROPEAN PATENT SPECIFICATION

(11) **EP 4 528 688 B1**
(45) Date of publication and mention of the grant of the patent: **07.10.2026**
(21) Application number: 23805863.0
(22) Date of filing: 07.04.2023
(51) Int. Cl.: G08G 1/00, B60W 30/10, G01R 33/02, G01V 3/08, G05D 1/646

(54) **SELF-DRIVING CONTROL SYSTEM AND SELF-DRIVING CONTROL METHOD**
SELBSTFAHRENDES STEUERUNGSSYSTEM UND SELBSTFAHRENDES STEUERUNGSVERFAHREN
SYSTÈME DE COMMANDE À CONDUITE AUTONOME ET PROCÉDÉ DE COMMANDE À CONDUITE AUTONOME

(30) Priority: 16.05.2022 JP 2022080439
(43) Date of publication of application: 26.03.2025
(73) Proprietor: Integral Geometry Science Inc., Kobe-shi, Hyogo 657-8501 (JP)
(72) Inventor: SUZUKI, Shogo, Kobe-shi, Hyogo 657-8501 (JP); MIMA, Yuki, Kobe-shi, Hyogo 657-8501 (JP); NISHIMURA, Yutaro, Kobe-shi, Hyogo 657-8501 (JP); MATSUDA, Seiju, Kobe-shi, Hyogo 657-8501 (JP); KIMURA, Kenjiro, Kobe-shi, Hyogo 657-8501 (JP); KIMURA, Noriaki, Kobe-shi, Hyogo 657-8501 (JP)
(74) Representative: KATZAROV S.A.
(86) International application number: PCT/JP2023/014379
(87) International publication number: WO 2023/223706

(56) References cited:
- WO-A1-2017/187879
- JP-A- 2001 134 896
- US-B1- 6 378 772
- US-B1- 9 278 691
- YAOGUO LI ET AL: "Enhancement of Magnetic Data by Stable Downward Continuation for UXO Application", IEEE TRANSACTIONS ON GEOSCIENCE AND REMOTE SENSING, IEEE, USA, vol. 51, no. 6, 1 June 2013 (2013-06-01), pages 3605 - 3614, XP011510393, ISSN: 0196-2892, DOI: 10.1109/TGRS.2012.2220146

## Description

### [Technical Field]

The present disclosure relates to an autonomous driving control system and the like for a vehicle that travels on a road provided with markers.

### [Background Art]

Conventionally, autonomous driving of vehicles has been under research and development. The technique described in Patent Literature (PTL) 1 relates to such autonomous driving. More specifically, PTL 1 discloses a vehicle automatic traveling system that travels with automatic steering by detecting magnetic markers laid along the travel path of the vehicle.

PTL 2 and Non-Patent Literature (NPTL) 3 also describe conventional autonomous driving control systems for a vehicle.

### [Citation List]

### [Patent Literature]

[PTL 1] Japanese Unexamined Patent Application Publication No. 2005-202478.
[PTL 2] US granted patent Publication No. 6 378 772.
[NPTL 3] YAOGUO LI ET AL: "Enhancement of Magnetic 1-16 Data by Stable Downward Continuation for UXO Application", IEEE TRANSACTIONS ON GEOSCIENCE AND REMOTE SENSING, IEEE, USA, vol. 51, no. 6, 1 June 2013 (2013-06-01), pages 3605-3614.

### [Summary of Invention]

### [Technical Problem]

However, manholes, fallen objects, floor slabs buried under asphalt, reinforcing steel bars for concrete, bridge reinforcing bars, water pipes, culverts, and covers of utility tunnels may affect the magnetic field. Therefore, it may be difficult to identify a marker, and it may be difficult to control the travel of the vehicle.

In view of this, the present disclosure provides an autonomous driving control system and the like that can appropriately control the travel of the vehicle according to the markers.

### [Solution to Problem]

An autonomous driving control system according to one aspect of the present disclosure is disclosed in the claims.

These general or specific aspects may be implemented as a system, a device or apparatus, a method, an integrated circuit, a computer program, or a non-transitory computer-readable recording medium such a CD-ROM, or any combination thereof.

### [Advantageous Effects of Invention]

According to one aspect of the present disclosure, it is possible to appropriately control the travel of the vehicle according to the markers.

### [Brief Description of Drawings]

[FIG. 1]

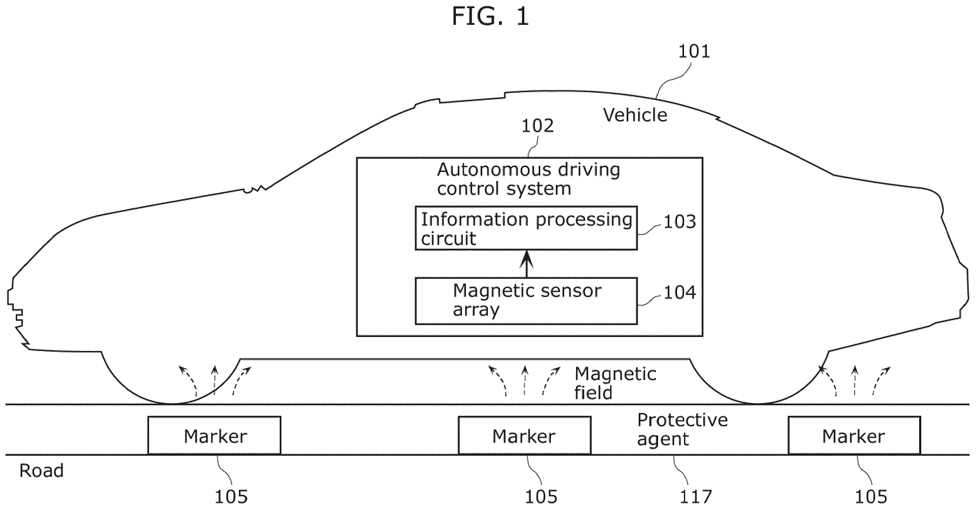

   FIG. 1 is a conceptual diagram illustrating the configuration of an autonomous driving control system according to an embodiment of the present disclosure.
[FIG. 2]

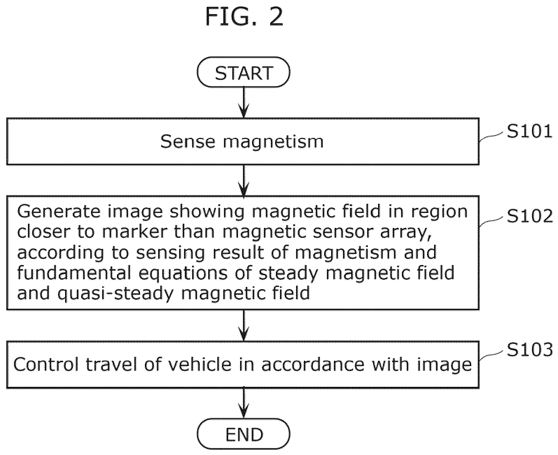

   FIG. 2 is a flowchart illustrating operations performed by an autonomous driving control system according to an embodiment of the present disclosure.
[FIG. 3]

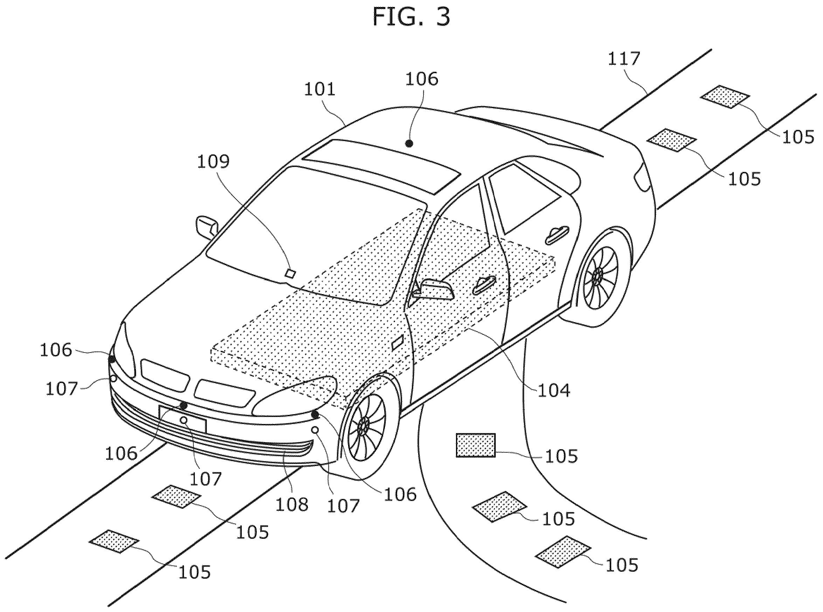

   FIG. 3 is a perspective view of a vehicle according to an embodiment of the present disclosure.
[FIG. 4]

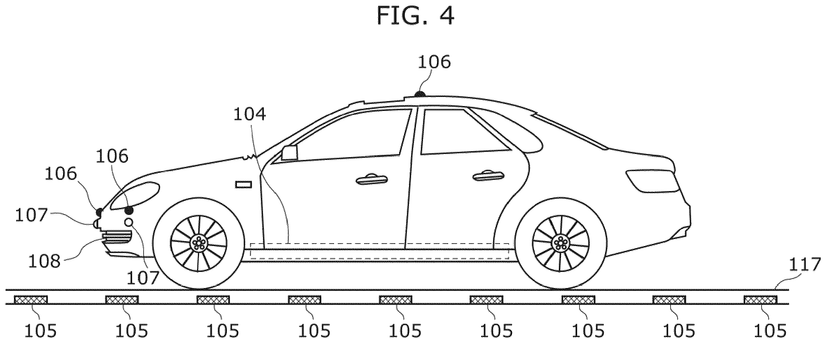

   FIG. 4 is a side view of a vehicle according to an embodiment of the present disclosure.
[FIG. 5]

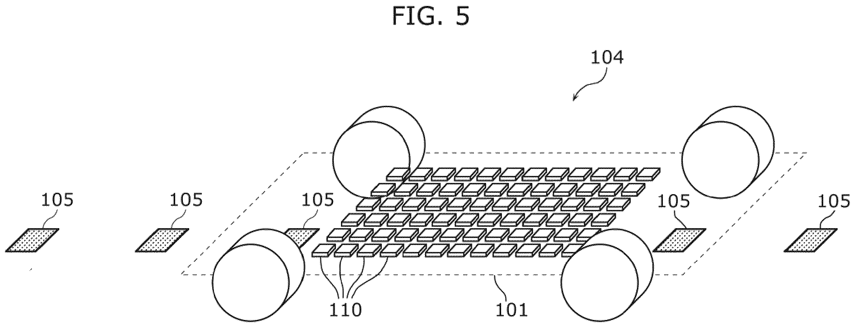

   FIG. 5 is a conceptual diagram illustrating a first example of a magnetic sensor array according to an embodiment of the present disclosure.
[FIG. 6]

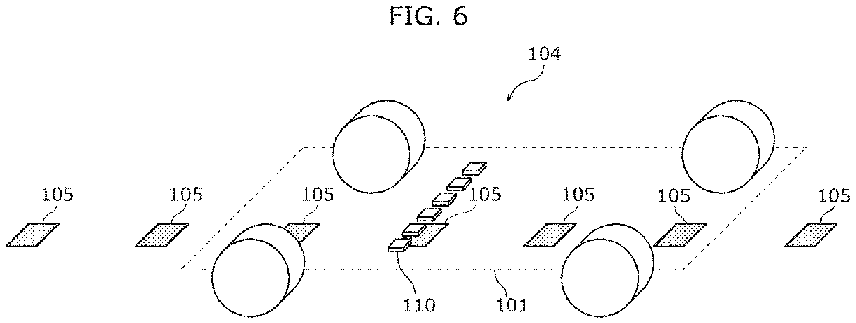

   FIG. 6 is a conceptual diagram illustrating a second example of a magnetic sensor array according to an embodiment of the present disclosure.
[FIG. 7]

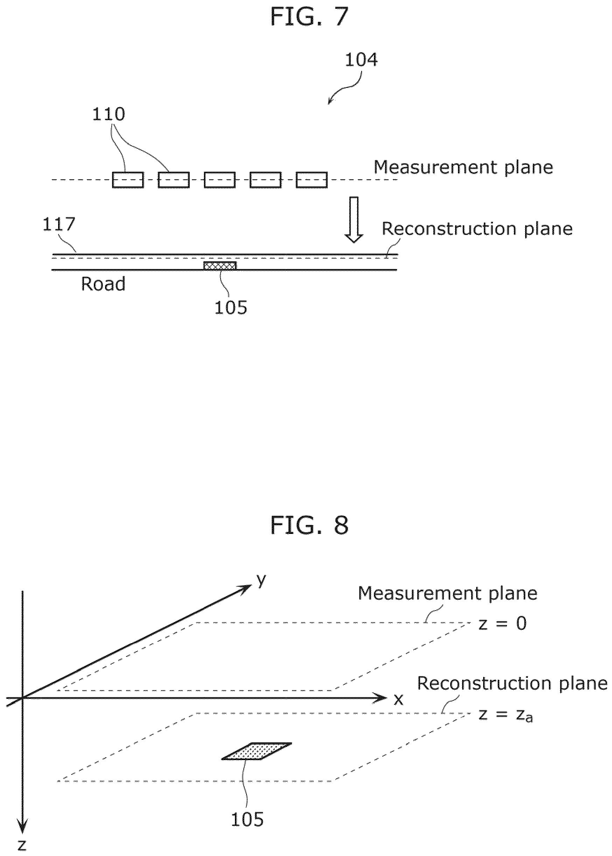

   FIG. 7 is a conceptual diagram illustrating a first example of reconstruction according to an embodiment of the present disclosure.
[FIG. 8]
   FIG. 8 is a conceptual diagram illustrating a coordinate system for the first example of the reconstruction according to an embodiment of the present disclosure.
[FIG. 9]

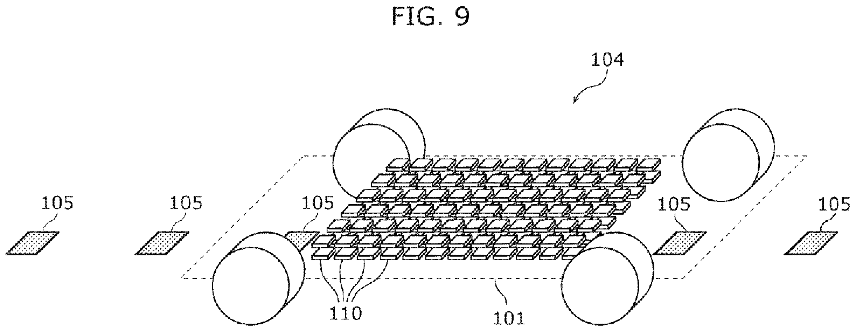

   FIG. 9 is a conceptual diagram illustrating a third example of a magnetic sensor array according to an embodiment of the present disclosure.
[FIG. 10]

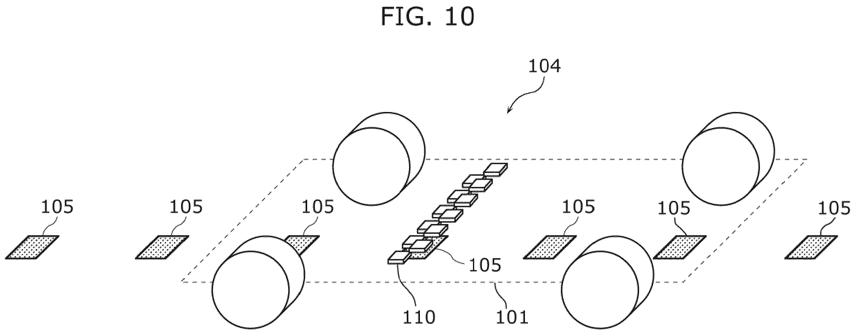

   FIG. 10 is a conceptual diagram illustrating a fourth example of a magnetic sensor array according to an embodiment of the present disclosure.
[FIG. 11]

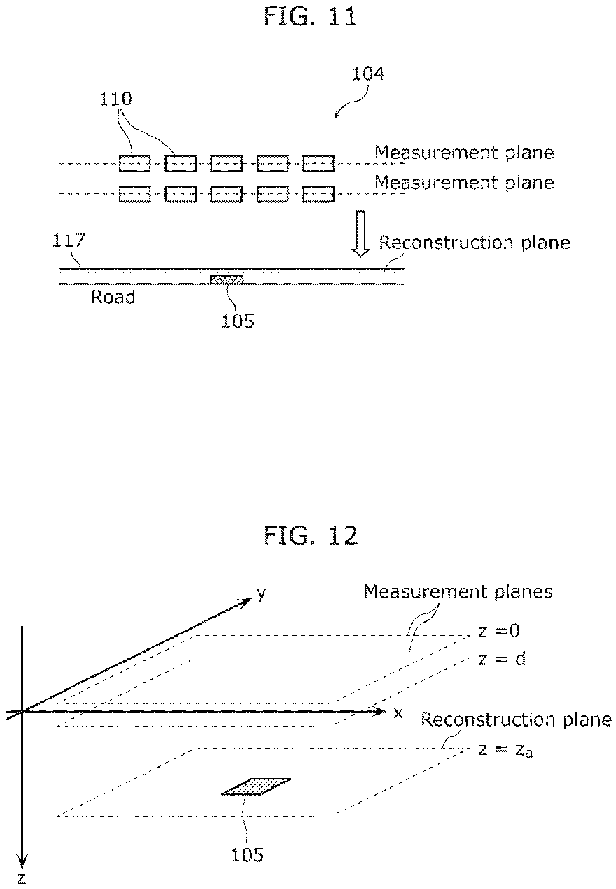

   FIG. 11 is a conceptual diagram illustrating a second example of reconstruction according to an embodiment of the present disclosure.
[FIG. 12]
   FIG. 12 is a conceptual diagram illustrating a coordinate system for the second example of the reconstruction according to an embodiment of the present disclosure.
[FIG. 13]

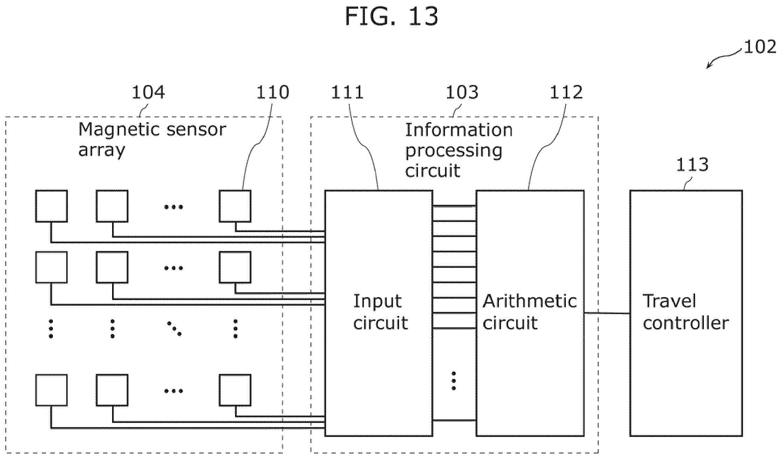

   FIG. 13 is a block diagram illustrating the details of the configuration of the autonomous driving control system according to an embodiment of the present disclosure.
[FIG. 14]

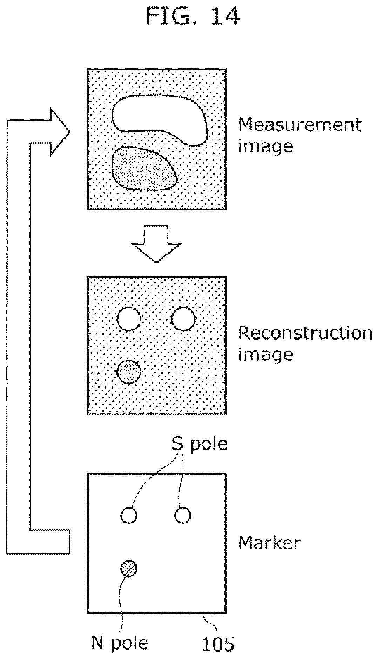

   FIG. 14 is a conceptual diagram illustrating a marker, a measurement image, and a reconstruction image according to an embodiment of the present disclosure.
[FIG. 15]

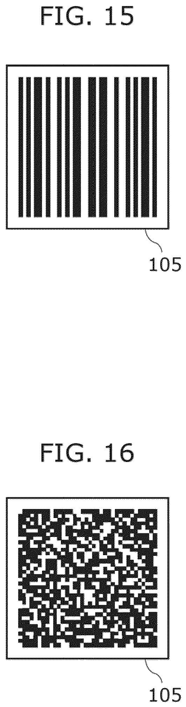

   FIG. 15 is a conceptual diagram illustrating a first example of a marker according to an embodiment of the present disclosure.
[FIG. 16]
   FIG. 16 is a conceptual diagram illustrating a second example of a marker according to an embodiment of the present disclosure.
[FIG. 17]

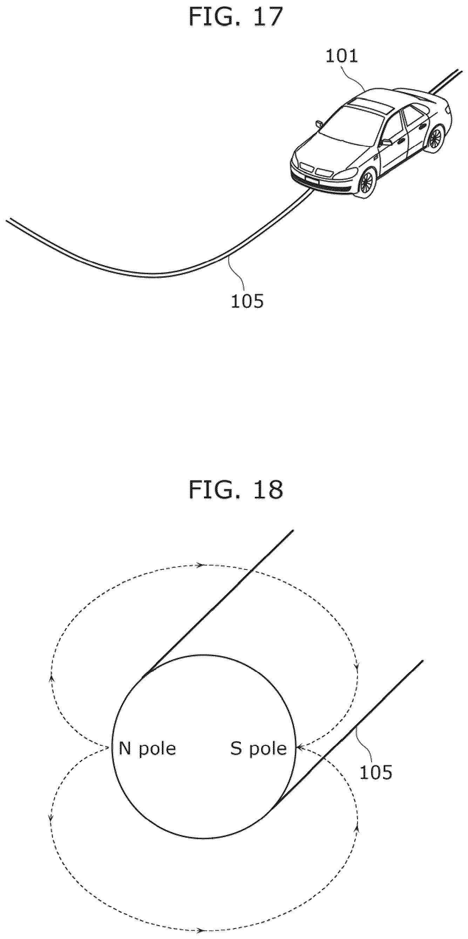

   FIG. 17 is a conceptual diagram illustrating a third example of a marker according to an embodiment of the present disclosure.
[FIG. 18]
   FIG. 18 is a conceptual diagram illustrating the magnetic field around a magnetic wire according to an embodiment of the present disclosure.
[FIG. 19]

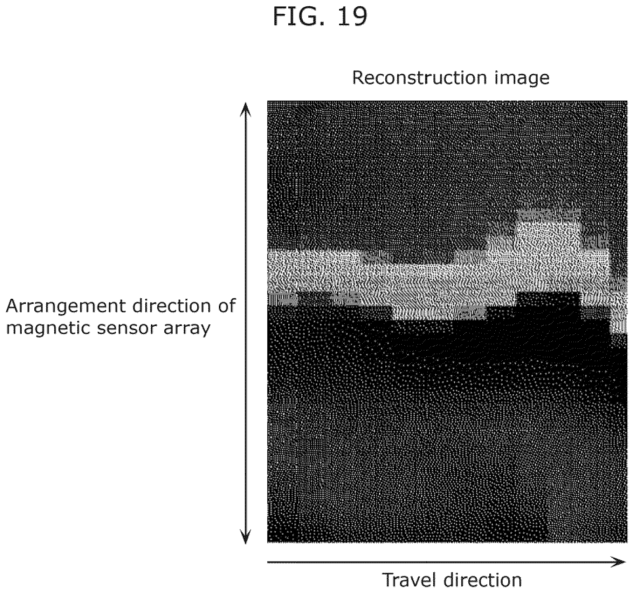

   FIG. 19 shows a reconstruction image in a case where a magnetic wire is used according to an embodiment of the present disclosure.
[FIG. 20]

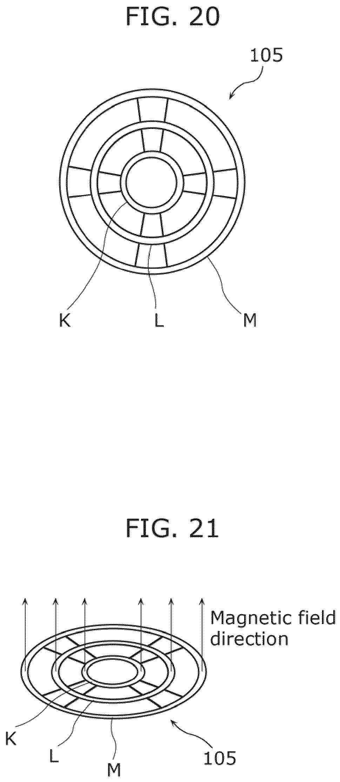

   FIG. 20 is a conceptual diagram illustrating a fourth example of a marker according to an embodiment of the present disclosure.
[FIG. 21]
   FIG. 21 is a conceptual diagram illustrating the magnetic field direction around a concentric marker according to an embodiment of the present disclosure.
[FIG. 22]

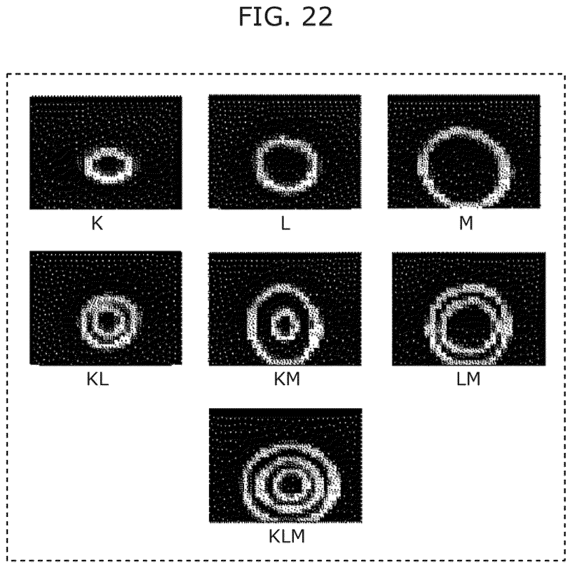

   FIG. 22 shows reconstruction images in a case where a concentric marker is used according to an embodiment of the present disclosure.
[FIG. 23]

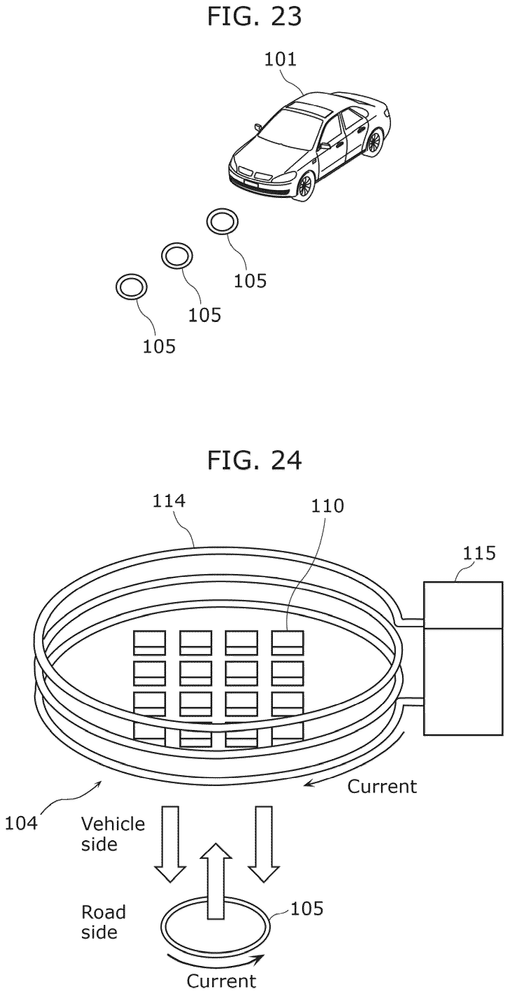

   FIG. 23 is a conceptual diagram illustrating a fifth example of a marker according to an embodiment of the present disclosure.
[FIG. 24]
   FIG. 24 is a conceptual diagram illustrating an induction circuit according to an embodiment of the present disclosure.
[FIG. 25]

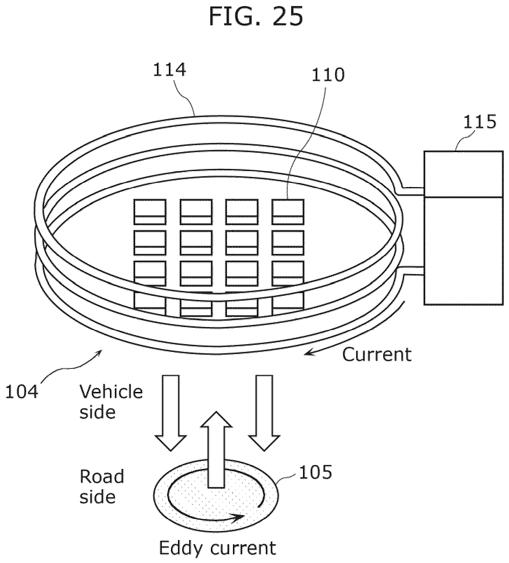

   FIG. 25 is a conceptual diagram illustrating another example of an electric conductor according to an embodiment of the present disclosure.
[FIG. 26]

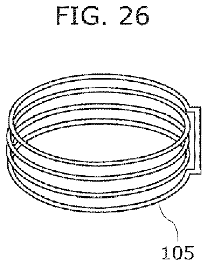

   FIG. 26 is a conceptual diagram illustrating yet another example of an electric conductor according to an embodiment of the present disclosure.
[FIG. 27]

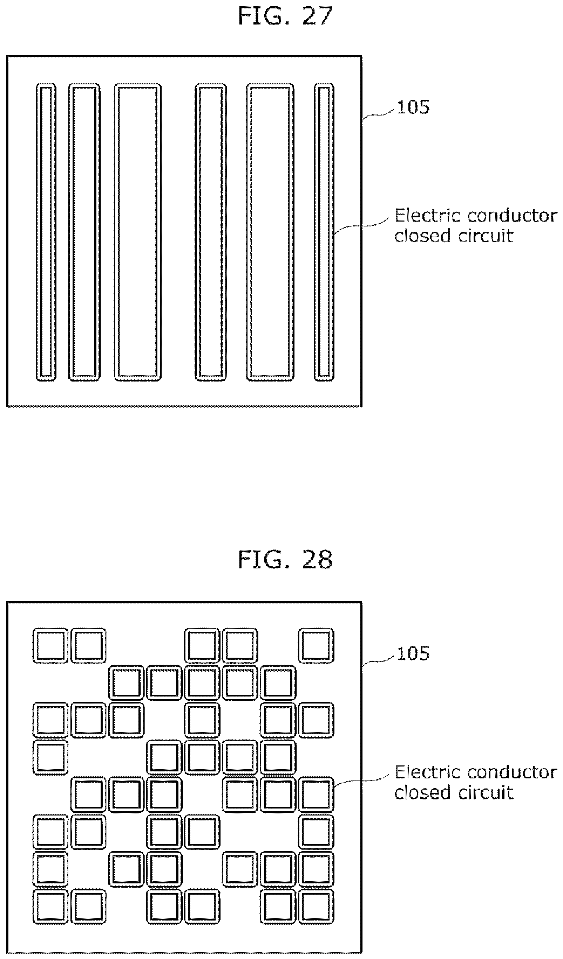

   FIG. 27 is a conceptual diagram illustrating an example of an electric conductor corresponding to the first example of a marker according to an embodiment of the present disclosure.
[FIG. 28]
   FIG. 28 is a conceptual diagram illustrating an example of an electric conductor corresponding to the second example of a marker according to an embodiment of the present disclosure.
[FIG. 29]

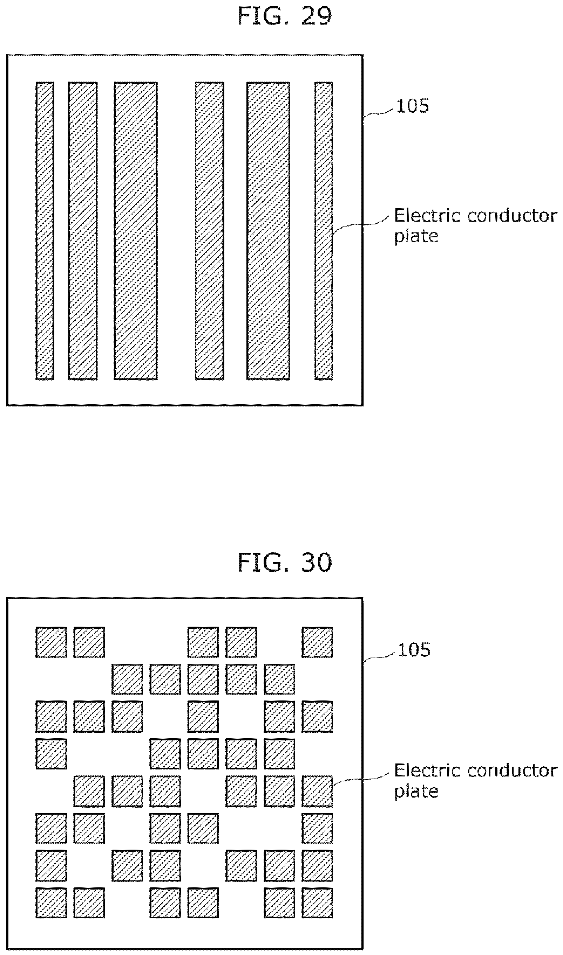

   FIG. 29 is a conceptual diagram illustrating another example of an electric conductor corresponding to the first example of a marker according to an embodiment of the present disclosure.
[FIG. 30]
   FIG. 30 is a conceptual diagram illustrating another example of an electric conductor corresponding to the second example of a marker according to an embodiment of the present disclosure.
[FIG. 31]

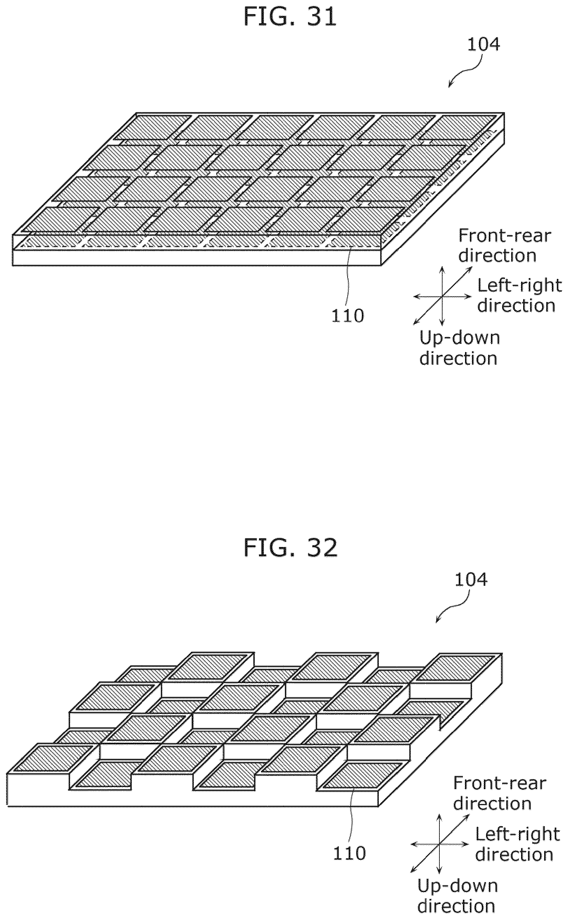

   FIG. 31 is a conceptual diagram illustrating a first specific example of a magnetic sensor array according to an embodiment of the present disclosure.
[FIG. 32]
   FIG. 32 is a conceptual diagram illustrating a second specific example of a magnetic sensor array according to an embodiment of the present disclosure.
[FIG. 33]

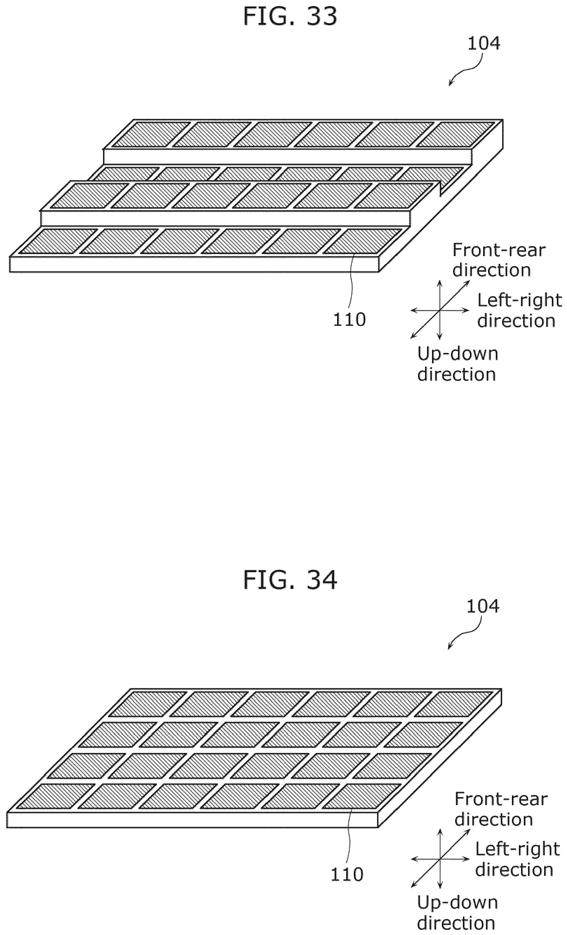

   FIG. 33 is a conceptual diagram illustrating a third specific example of a magnetic sensor array according to an embodiment of the present disclosure.
[FIG. 34]
   FIG. 34 is a conceptual diagram illustrating a fourth specific example of a magnetic sensor array according to an embodiment of the present disclosure.
[FIG. 35]

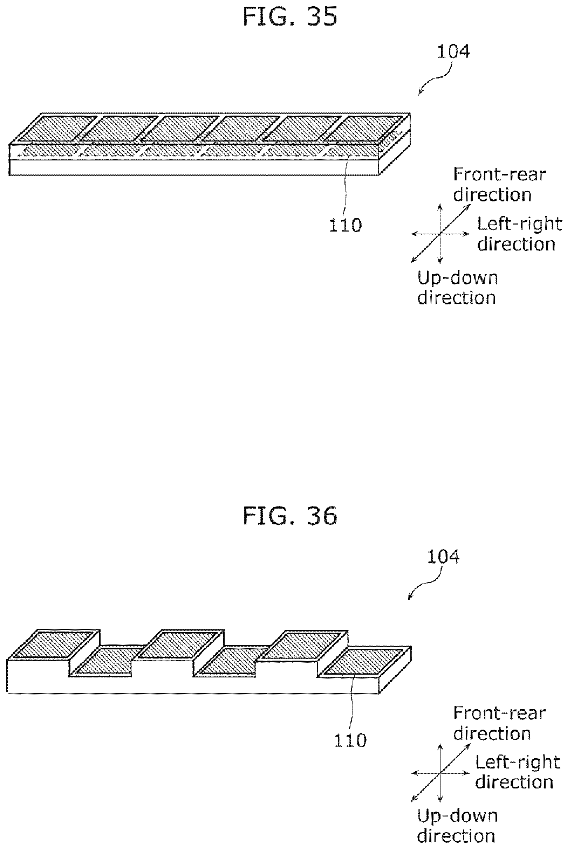

   FIG. 35 is a conceptual diagram illustrating a fifth specific example of a magnetic sensor array according to an embodiment of the present disclosure.
[FIG. 36]
   FIG. 36 is a conceptual diagram illustrating a sixth specific example of a magnetic sensor array according to an embodiment of the present disclosure.
[FIG. 37]

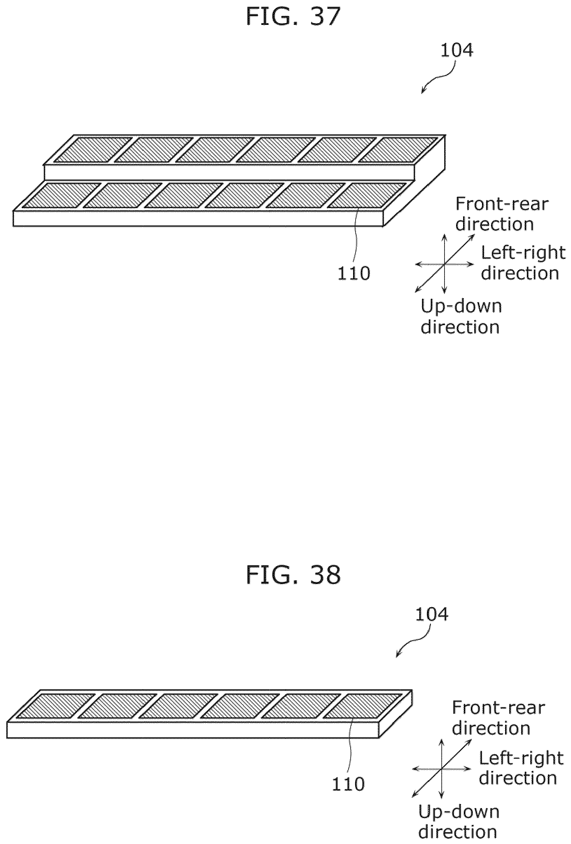

   FIG. 37 is a conceptual diagram illustrating a seventh specific example of a magnetic sensor array according to an embodiment of the present disclosure.
[FIG. 38]
   FIG. 38 is a conceptual diagram illustrating an eighth specific example of a magnetic sensor array according to an embodiment of the present disclosure.
[FIG. 39]

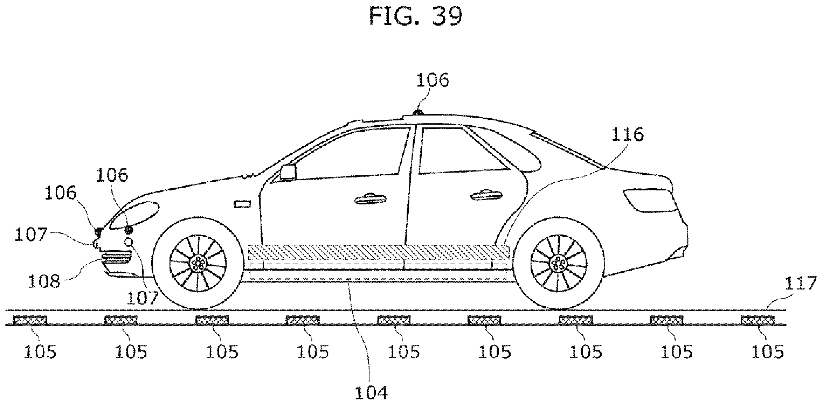

   FIG. 39 is a conceptual diagram illustrating a magnetic shield according to an embodiment of the present disclosure.
[FIG. 40]

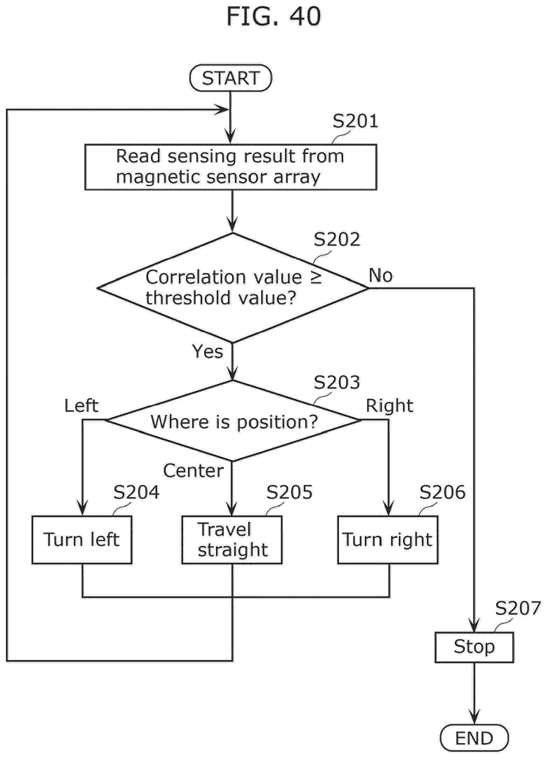

   FIG. 40 is a flowchart illustrating a travel control process according to an embodiment of the present disclosure.
[FIG. 41]

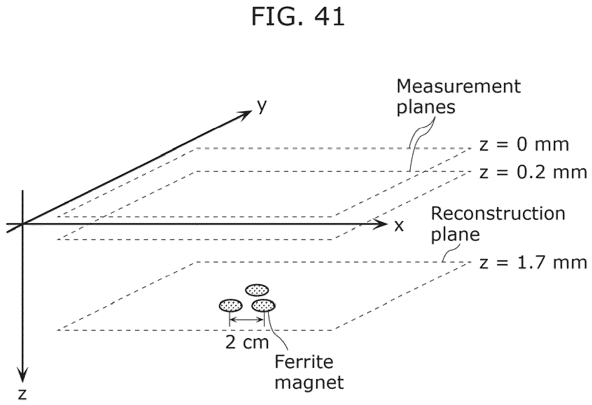

   FIG. 41 is a conceptual diagram illustrating a basic experiment according to an embodiment of the present disclosure.
[FIG. 42]

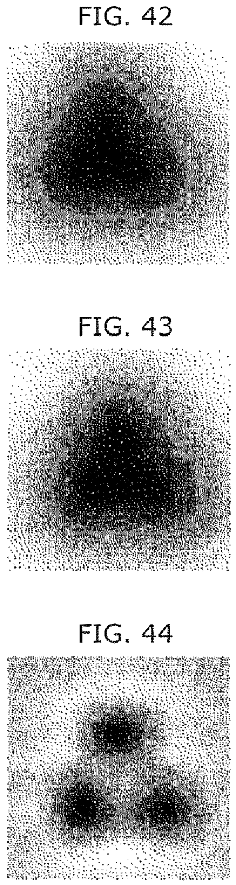

   FIG. 42 shows a first measurement image obtained in a basic experiment according to an embodiment of the present disclosure.
[FIG. 43]
   FIG. 43 shows a second measurement image obtained in a basic experiment according to an embodiment of the present disclosure.
[FIG. 44]
   FIG. 44 shows a reconstruction image obtained in a basic experiment according to an embodiment of the present disclosure.
[FIG. 45]

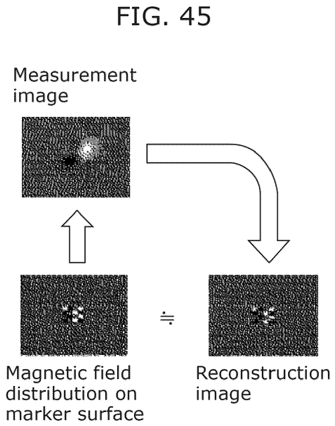

   FIG. 45 is a conceptual diagram illustrating the relationship between a measurement image and a reconstruction image for verification according to an embodiment of the present disclosure.
[FIG. 46]

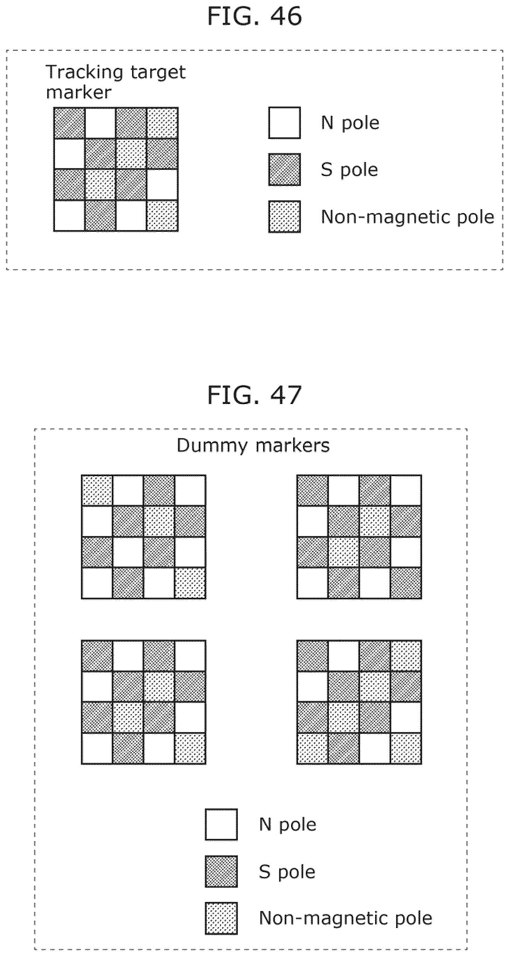

   FIG. 46 is a conceptual diagram illustrating a tracking target marker for verification according to an embodiment of the present disclosure.
[FIG. 47]
   FIG. 47 is a conceptual diagram illustrating dummy markers for verification according to an embodiment of the present disclosure.
[FIG. 48]

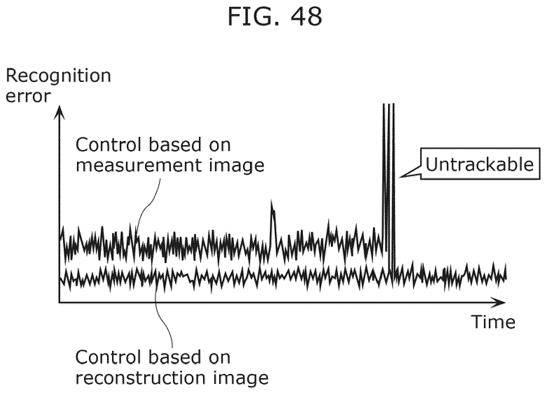

   FIG. 48 is a graph illustrating verification results according to an embodiment of the present disclosure.

### [Description of Embodiments]

Generally, autonomous driving refers to the automation of driving tasks. Autonomous driving capabilities are classified into six levels, ranging from Level 0 to Level 5. Among these levels, Level 5 is also called full autonomous driving. In Level 5, all driving tasks to the destination are performed by the system. This means the driving tasks are not monitored by a human driver. Therefore, there is no room for error in Level 5 implementations.

Various sensing techniques for realizing autonomous driving are being researched and developed. More specifically, the use of cameras, LiDAR (Light Detection and Ranging), millimeter-wave radar, and ultrasonic sonar for autonomous driving is being researched and developed. For example, object detection and object recognition are performed by a camera. As a result, collision avoidance and white line recognition are performed. For example, the distance to objects is measured by LiDAR, millimeter-wave radar, and ultrasonic sonar, and collision avoidance is performed.

Furthermore, for example, the realization of autonomous driving using artificial intelligence (AI) composed of, for example, neural networks is being researched and developed. More specifically, in AI, driving tasks performed by drivers and corresponding images obtained from cameras are learned in advance. When the same image is obtained from the camera, the same driving task is reproduced by the AI. For example, white line recognition is carried out using a camera and AI, and the driving task is reproduced so that the vehicle moves along the white line. This enables the vehicle to move along the road.

For example, the use of markers such as magnetic markers for autonomous driving is also being researched and developed. More specifically, markers provided on the road are detected by a magnetic sensor equipped on a vehicle. The vehicle is controlled to move along the markers provided along the road.

For example, depending on weather conditions, it may be difficult to recognize white lines using a camera and AI. Therefore, there is a possibility of malfunction depending on weather conditions, and autonomous driving may be difficult. Thus, using markers that are less susceptible to weather conditions for autonomous driving is effective.

However, manholes, fallen objects, floor slabs buried under asphalt, reinforcing steel bars for concrete, bridge reinforcing bars, water pipes, culverts, and covers of utility tunnels may affect the magnetic field. Therefore, it may be difficult to identify the marker, and it may be difficult to control the travel of the vehicle.

For example, an autonomous driving control system according to one aspect of the present disclosure is for a vehicle that travels on a road provided with a marker that emits a steady magnetic field or a quasi-steady magnetic field, and includes: a magnetic sensor array that is equipped on the vehicle and senses magnetism; and an information processing circuit that generates an image showing a magnetic field in a region closer to the marker than the magnetic sensor array, according to a sensing result of the magnetism and a fundamental equation of the steady magnetic field and the quasi-steady magnetic field, and controls travel of the vehicle according to the image.

This enables the autonomous driving control system to control the travel of the vehicle according to an image showing the magnetic field in a region closer to the marker than the magnetic sensor array. This image is assumed to show the marker with high accuracy. It is therefore assumed that the marker can be appropriately identified. Therefore, the autonomous driving control system can appropriately control the travel of the vehicle according to the marker.

For example, the information processing circuit: obtains a speed of the vehicle; converts temporal changes in the sensing result into spatial changes according to the speed; and generates the image according to the fundamental equation and the sensing result in which the temporal changes have been converted into the spatial changes.

Accordingly, the autonomous driving control system can sufficiently obtain the spatial change of the magnetic field according to the temporal changes in sensing results and the speed of the vehicle. Therefore, the autonomous driving control system can adequately generate an image showing the magnetic field.

For example, the magnetic sensor array includes one or more two-dimensional magnetic sensor arrays arranged in a front-rear direction and a left-right direction of the vehicle.

Accordingly, the autonomous driving control system can sufficiently obtain the spatial change of the magnetic field with a two-dimensional magnetic sensor array. Therefore, the autonomous driving control system can adequately generate an image showing the magnetic field.

For example, the magnetic sensor array includes one or more one-dimensional magnetic sensor arrays arranged in a left-right direction of the vehicle.

This enables the autonomous driving control system to appropriately control the travel of the vehicle with few resources and at low cost.

For example, the magnetic sensor array senses the magnetism in one layer arranged in a front-rear direction and a left-right direction of the vehicle.

This enables the autonomous driving control system to sense magnetism in a simple manner and perform processing with a low computational load.

For example, the magnetic sensor array senses the magnetism in two layers arranged in a front-rear direction and a left-right direction of the vehicle.

This enables the autonomous driving control system to appropriately obtain the gradient of the magnetic field in the up-down direction and adequately generate an image showing the magnetic field.

For example, the information processing circuit generates the image according to Equation (5) to be described later which is in accordance with the sensing result and the fundamental equation, where: Hᵢ(x, y, z) is an i component in a magnetic field at a coordinate position (x, y, z); i is x, y, or z; z is a coordinate value in a z-direction from a top of the vehicle toward a bottom of the vehicle; x is a coordinate value in an x-direction orthogonal to the z-direction, y is a coordinate value in a y-direction orthogonal to the z-direction and the x-direction, f(kₓ, k_{y}) is a two-dimensional Fourier transform image of Hᵢ(x, y, 0) indicating the sensing result at (x, y, 0) which is a measurement plane; kₓ is a wavenumber with respect to x, and k_{y} is a wavenumber with respect to y.

This enables the autonomous driving control system to adequately generate an image showing the magnetic field in a region closer to a marker than the magnetic sensor array, using the sensing result.

For example, the information processing circuit generates the image according to Equation (9) to be described later which is in accordance with the sensing result and the fundamental equation, where: Hᵢ(x, y, z) is an i component in a magnetic field at a coordinate position (x, y, z); i is x, y, or z; z is a coordinate value in a z-direction from a top of the vehicle toward a bottom of the vehicle; x is a coordinate value in an x-direction orthogonal to the z-direction, y is a coordinate value in a y-direction orthogonal to the z-direction and the x-direction, f(kₓ, k_{y}) is a two-dimensional Fourier transform image of Hᵢ(x, y, 0) indicating the sensing result at (x, y, 0) which is a measurement plane; g(kₓ, k_{y}) is a two-dimensional Fourier transform image of ∂/∂zHᵢ(x, y, z)|_{z=0} indicating a gradient in the z-direction of the sensing result at (x, y, 0) which is the measurement plane; kₓ is a wavenumber with respect to x, and k_{y} is a wavenumber with respect to y.

This enables the autonomous driving control system to adequately generate an image showing the magnetic field in a region closer to a marker than the magnetic sensor array, using the sensing result and its gradient.

For example, the autonomous driving control system further includes: at least one of a camera, a LiDAR, a millimeter-wave radar, an ultrasonic sonar, or a GPS receiver equipped on the vehicle. The information processing circuit further controls the travel of the vehicle according to the at least one of the camera, the LiDAR, the millimeter-wave radar, the ultrasonic sonar, or the GPS receiver.

This enables the autonomous driving control system to control the travel of the vehicle according to various information obtained from a camera, a LiDAR, a millimeter-wave radar, an ultrasonic sonar, or a GPS receiver.

For example, the autonomous driving control system further includes the marker provided on the road.

This enables the autonomous driving control system to control the travel of the vehicle according to the marker included in the autonomous driving control system.

For example, the marker includes a plurality of markers provided on the road, and the plurality of markers emit steady magnetic fields or quasi-steady magnetic fields with a plurality of magnetic patterns for controlling the travel of the vehicle.

This enables the autonomous driving control system to control the travel of the vehicle according to a plurality of magnetic patterns.

For example, each of the plurality of magnetic patterns is a concentric magnetic pattern.

This enables the autonomous driving control system to inhibit the influence of the orientation of the vehicle in the identification of magnetic patterns.

For example, each of the plurality of magnetic patterns is a barcode-like magnetic pattern.

This enables the autonomous driving control system to control the travel of the vehicle according to a barcode that can simply indicate various information.

For example, each of the plurality of magnetic patterns is a two-dimensional code-like magnetic pattern.

This enables the autonomous driving control system to control the travel of the vehicle according to a two-dimensional code that can indicate a greater variety of information.

For example, the marker represents a code sequence, as an arrangement of a plurality of magnetic poles, for controlling the travel of the vehicle, the code sequence includes a code for error detection, and the information processing circuit: reads the code sequence according to the image; determines whether the code sequence read includes an error according to the code included in the code sequence read; and controls the travel of the vehicle in accordance with the code sequence read on condition that the code sequence read is determined to include no error.

This enables the autonomous driving control system to read a code sequence from the marker via an image indicating the magnetic field. The autonomous driving control system can determine whether the read-out code sequence includes an error according to the code for error detection. Accordingly, the autonomous driving control system can appropriately control the travel of the vehicle according to a highly reliable code sequence.

For example, the marker has a wire-like shape.

This enables the autonomous driving control system to control the travel of the vehicle along a wire-like shape.

For example, the marker is a magnetic material that is magnetic.

This enables the autonomous driving control system to control the travel of the vehicle using a simple marker.

For example, the marker is an electric conductor that is conductive.

This enables the autonomous driving control system to appropriately control the travel of the vehicle using an electric conductor as the marker.

For example, the autonomous driving control system further includes: an induction circuit that is equipped on the vehicle and induces a first magnetic field component. The marker emits the steady magnetic field or the quasi-steady magnetic field by inducing a second magnetic field component in response to the first magnetic field component.

This enables the autonomous driving control system to appropriately generate a magnetic field from the marker even when an electric conductor is used as the marker.

For example, a vehicle according to one aspect of the present disclosure includes the autonomous driving control system.

This enables the vehicle to control its travel according to an image showing the magnetic field in a region closer to the marker than the magnetic sensor array.

For example, an autonomous driving control method according to one aspect of the present disclosure is for a vehicle that travels on a road provided with a marker that emits a steady magnetic field or a quasi-steady magnetic field, and includes: sensing magnetism by a magnetic sensor array equipped on the vehicle; and generating an image showing a magnetic field in a region closer to the marker than the magnetic sensor array, according to a sensing result of the magnetism and a fundamental equation of the steady magnetic field and the quasi-steady magnetic field, and controlling travel of the vehicle according to the image.

This makes it possible to control the travel of the vehicle according to an image showing the magnetic field in a region closer to the marker than the magnetic sensor array. This image is assumed to show the marker with high accuracy. It is therefore assumed that the marker can be appropriately identified. It therefore becomes possible to appropriately control the travel of the vehicle according to the marker.

Hereinafter, embodiments will be described with reference to the drawings. Each of the following embodiments describes a general or specific example. The numerical values, shapes, materials, elements, the arrangement and connection of the elements, steps, the order of the steps etc., presented in the following embodiments are mere examples, and do not limit the scope of the claims.

The magnetic field components described in the present disclosure are the components that make up the magnetic field. The magnetic field components may be each of several magnetic fields superimposed on the overall magnetic field. In addition, the devices described in the present disclosure may include a plurality of elements arranged in a distributed manner.

### [Embodiment]

FIG. 1 is a conceptual diagram illustrating the configuration of the autonomous driving control system according to the present embodiment. Vehicle 101 illustrated in FIG. 1 is a machine that travels on a road, and specifically is an automobile. Vehicle 101 can also be referred to as an autonomous driving vehicle.

Autonomous driving control system 102 is a system that controls the travel of vehicle 101. More specifically, autonomous driving control system 102 controls the travel of vehicle 101 in accordance with markers 105 provided on the road. Controlling travel of vehicle 101 by autonomous driving control system 102 includes, for example, controlling vehicle 101 to travel straight, turn left, turn right, stop, etc.

For example, a plurality of markers 105 are provided along the road. More specifically, a plurality of markers 105 are provided on the road surface and covered by protective agent 117. Autonomous driving control system 102 drives vehicle 101 along the plurality of markers 105 provided along the road.

Autonomous driving control system 102 includes information processing circuit 103 and magnetic sensor array 104.

Information processing circuit 103 is an electric circuit that performs information processing. Information processing circuit 103 generates an image showing the magnetic field in a region closer to marker 105 than magnetic sensor array 104, according to the sensing result of magnetism sensed by magnetic sensor array 104 and the fundamental equation of the steady magnetic field and the quasi-steady magnetic field.

A steady magnetic field is, for example, a static magnetic field that does not change over time. A quasi-steady magnetic field is, for example, a magnetic field in which temporal changes are smaller than a reference. More specifically, the quasi-steady magnetic field may be a magnetic field that changes at or below a reference frequency. This reference frequency may be 1 kHz, several hundred Hz, several tens of Hz, or several Hz.

The region closer to marker 105 than magnetic sensor array 104 may specifically be a region closer to the estimated position of marker 105 than magnetic sensor array 104, and may be defined as a position lower than magnetic sensor array 104. The region closer to marker 105 than magnetic sensor array 104 may be a region closer to the road surface than magnetic sensor array 104. The luminance of the image may correspond to the strength of the magnetic field. Information processing circuit 103 controls the travel of vehicle 101 in accordance with the generated image.

For example, information processing circuit 103 reads out information for controlling vehicle 101 from the generated image. More specifically, information processing circuit 103 reads out information such as travel straight, turn left, turn right, or stop. Information processing circuit 103 then controls the travel of vehicle 101 according to the read-out information.

Magnetic sensor array 104 is a device that senses magnetism. Magnetic sensor array 104 senses the magnetism of a magnetic field that includes a magnetic field component induced by marker 105 provided on the road. More specifically, for example, magnetic sensor array 104 includes a plurality of magnetic sensors and senses the magnetism of a magnetic field that includes a magnetic field component induced by marker 105 provided on the road with each magnetic sensor.

Marker 105 induces a magnetic field component. More specifically, marker 105 emits a steady magnetic field or a quasi-steady magnetic field. For example, a plurality of markers 105 are provided along the road. Marker 105 may be referred to as a magnetic marker.

For example, marker 105 is an electric conductor that is conductive, such as a ring or coil. Marker 105 embodied as an electric conductor that is conductive may induce a magnetic field component based on electromagnetic induction. The realisation of marker 105 as a magnetic material, specifically a ferromagnetic material that is magnetic such as a permanent magnet, is not encompassed by the wording of the claims and is described only for understanding of the invention. This will be described in greater detail later.

For example, marker 105 may represent a code sequence, as an arrangement of a plurality of magnetic poles, for controlling travel of vehicle 101. Information processing circuit 103 may read out a code sequence in accordance with the generated image, and control the travel of vehicle 101 in accordance with the read-out code sequence.

For example, the code sequence represented by marker 105 may include a code for error detection. Information processing circuit 103 may determine whether the read-out code sequence includes an error according to the code for error detection. Information processing circuit 103 may control the travel of vehicle 101 in accordance with the read-out code sequence if it is determined that no error is included.

Information processing circuit 103 may ignore the read-out code sequence if it is determined that the read-out code sequence includes an error. In this case, information processing circuit 103 may output an alert indicating that the read-out code sequence includes an error. Alternatively, in this case, information processing circuit 103 may correct the error and control the travel of vehicle 101 in accordance with the error-corrected code sequence.

Protective agent 117 covers marker 105 and forms a layer for protecting marker 105. A protective film containing a resin or the like may be used as protective agent 117. A layer of protective agent 117 may be formed by applying a protective coating to the plurality of markers 105 and the road surface.

FIG. 2 is a flowchart illustrating operations performed by autonomous driving control system 102 illustrated in FIG. 1. Autonomous driving control system 102 performs the operations illustrated in FIG. 2.

First, magnetic sensor array 104 of autonomous driving control system 102 senses magnetism (S101). Next, information processing circuit 103 of autonomous driving control system 102 generates an image showing the magnetic field in a region closer to marker 105 than magnetic sensor array 104, according to the sensing result of magnetism and the fundamental equation of the steady magnetic field and the quasi-steady magnetic field (S102). Information processing circuit 103 controls the travel of vehicle 101 in accordance with the generated image (S103).

FIG. 3 is perspective view of vehicle 101 illustrated in FIG. 1. As illustrated in FIG. 3, vehicle 101 is controlled to travel along a plurality of markers 105 covered by protective agent 117. Magnetic sensor array 104 equipped on vehicle 101 is disposed at the lower portion of vehicle 101.

As illustrated in FIG. 3, at least one of one or more cameras 106, one or more LiDARs 107, one or more wave sensors 108, and global positioning system (GPS) receiver 109 may be equipped on vehicle 101. Here, wave sensor 108 may be a millimeter wave radar, an ultrasonic sonar, or a combination thereof.

Information processing circuit 103 may perform collision avoidance by controlling the traveling of vehicle 101 according to information obtained from the one or more cameras 106, the one or more LiDARs 107, and the one or more wave sensors 108. In doing so, information processing circuit 103 may perform collision avoidance by performing object detection and object recognition using a neural network.

Stated differently, control for causing vehicle 101 to travel along a road using markers 105 and control for performing collision avoidance using the one or more cameras 106, the one or more LiDARs 107, and the one or more wave sensors 108 may be combined. Furthermore, information processing circuit 103 may obtain position information of vehicle 101 from GPS receiver 109 and control the travel of vehicle 101 according to the position information.

Autonomous driving control system 102 may include at least one of: the one or more cameras 106; the one or more LiDARs 107; the one or more wave sensors 108; or GPS receiver 109.

FIG. 4 is side view of vehicle 101 illustrated in FIG. 1. As illustrated in FIG. 4, magnetic sensor array 104 is disposed at the lower portion of vehicle 101. Magnetic sensor array 104 senses the magnetism of a magnetic field that includes a magnetic field component induced by marker 105.

FIG. 5 is a conceptual diagram illustrating a first example of magnetic sensor array 104 illustrated in FIG. 1. In this example, magnetic sensor array 104 is a two-dimensional magnetic sensor array arranged in the front-rear direction and the left-right direction of vehicle 101. Stated differently, magnetic sensor array 104 includes a plurality of magnetic sensors 110 arranged in the front-rear direction and the left-right direction of vehicle 101.

FIG. 6 is a conceptual diagram illustrating a second example of magnetic sensor array 104 illustrated in FIG. 1. In this example, magnetic sensor array 104 is a one-dimensional magnetic sensor array arranged in the left-right direction of vehicle 101. Stated differently, magnetic sensor array 104 includes a plurality of magnetic sensors 110 arranged in the left-right direction of vehicle 101.

FIG. 7 is a conceptual diagram illustrating a first example of the reconstruction according to the present embodiment. For example, in the example of FIG. 6, by vehicle 101 traveling, magnetic sensor array 104, which is a one-dimensional magnetic sensor array, can scan a two-dimensional measurement plane above marker 105. This makes it possible to obtain a sensing result of magnetism on a two-dimensional measurement plane, that is, a two-dimensional sensing result.

For example, information processing circuit 103 obtains the speed of vehicle 101 from a speedometer or the like of vehicle 101, and converts the temporal changes in the sensing results in magnetic sensor array 104 into spatial changes according to the speed of vehicle 101. More specifically, the higher the speed of vehicle 101 is, the wider the range over which the temporal changes in the sensing results in magnetic sensor array 104 may be converted into spatial changes. This makes it possible to appropriately obtain a two-dimensional sensing result.

The operations described above may also be applied to the example in FIG. 5. More specifically, in magnetic sensor array 104, which is a two-dimensional magnetic sensor array, a one-dimensional magnetic sensor array can be considered to exist for each row in the left-right direction. Therefore, according to the above operations, a two-dimensional sensing result is obtained for each row in the left-right direction. This makes it possible to obtain a plurality of two-dimensional sensing results, one for each of the plurality of rows in the left-right direction.

A single two-dimensional sensing result obtained by combining the plurality of two-dimensional sensing results may be used in subsequent processing, or each of the plurality of two-dimensional sensing results may be used in subsequent processing.

Information processing circuit 103 generates an image showing the magnetic field in a reconstruction plane closer to marker 105 than the measurement plane, according to the sensing result of magnetism in the measurement plane and the fundamental equation of the steady magnetic field and the quasi-steady magnetic field.

FIG. 8 is a conceptual diagram illustrating the coordinate system for the reconstruction illustrated in FIG. 7. FIG. 8 expresses the measurement plane and the reconstruction plane in an xyz orthogonal coordinate system.

z is a coordinate value in the z-direction from the top of vehicle 101 toward the bottom, x is a coordinate value in the x-direction orthogonal to the z-direction, and y is a coordinate value in the y-direction orthogonal to the z-direction and the x-direction. For example, the x-direction corresponds to the left-right direction of vehicle 101, and the y-direction corresponds to the front-rear direction of vehicle 101. Alternatively, the x-direction corresponds to the front-rear direction of vehicle 101 and the y-direction corresponds to the left-right direction of vehicle 101. Moreover, the magnetic field is sensed at z=0. That is, z=0 corresponds to the measurement plane.

For example, the fundamental equation of the steady magnetic field and the quasi-steady magnetic field in free space "without a magnetic source including an induced magnetic field" is expressed by Laplace's equation. More specifically, the following Equation (1) holds true for Hᵢ(x, y, z), which is the i-component of the magnetic field vector in the xyz orthogonal coordinate system.
[Math. 1] ${ΔH}_{i} = 0$ (1)

For example, i is x, y, or z. Δ is the Laplacian, also called the Laplacian operator. A general solution of the above Equation (1) is expressed by the following Equation (2) as the sum of an exponentially increasing term and an exponentially decaying term in the z-direction.
[Math. 2] ${H}_{i} \left(x, y, z\right) = \frac{1}{{\left(2π\right)}^{2}} ∬ {e}^{{ik}_{x} x + {ik}_{y} y} \left\{a\left({k}_{x}, {k}_{y}\right){e}^{z \sqrt{{{k}_{x}}^{2} + {{k}_{y}}^{2}}}+b\left({k}_{x}, {k}_{y}\right){e}^{- z \sqrt{{{k}_{x}}^{2} + {{k}_{y}}^{2}}}\right\} {dk}_{x} {dk}_{y}$ (2)

In Equation (2) above, kₓ and k_{y} represent the wavenumbers in the x- and y-directions, respectively. Also, a(kₓ, k_{y}) and b(kₓ, k_{y}) are functions expressed in terms of kₓ and k_{y}. In this example, the magnetic source is assumed to be on the positive side in the z-direction. Therefore, for convenience, terms that decay exponentially in the z-direction are omitted. Therefore, Equation (2) is expressed as Equation (3) below.
[Math. 3] ${H}_{i} \left(x, y, z\right) = \frac{1}{{\left(2π\right)}^{2}} ∬ {e}^{{ik}_{x} x + {ik}_{y} y} \left\{a\left({k}_{x}, {k}_{y}\right){e}^{z \sqrt{{{k}_{x}}^{2} + {{k}_{y}}^{2}}}\right\} {dk}_{x} {dk}_{y}$ (3)

For example, Hᵢ(x, y, 0), which is the i component of the magnetic field vector in the z=0 plane, is obtained by the measurement. Using this, a(kₓ, k_{y}) in Equation (3) is calculated as in Equation (4) below.
[Math. 4] $a \left({k}_{x}, {k}_{y}\right) = f \left({k}_{x}, {k}_{y}\right)$ (4)

Here, f(kₓ, k_{y}) is the two-dimensional Fourier transform image of Hᵢ(x, y, 0). By substituting Equation (4) into Equation (3), Hᵢ(x, y, z) is obtained as in Equation (5) below.
[Math. 5] ${H}_{i} \left(x, y, z\right) = \frac{1}{{\left(2π\right)}^{2}} ∬ {e}^{{ik}_{x} x + {ik}_{y} y} \left\{f\left({k}_{x}, {k}_{y}\right){e}^{z \sqrt{{{k}_{x}}^{2} + {{k}_{y}}^{2}}}\right\} {dk}_{x} {dk}_{y}$ (5)

As described above, Equation (5) representing the magnetic field (specifically, the i component of the magnetic field vector) is derived according to the sensing result of the magnetic field and the fundamental equation of the steady magnetic field and the quasi-steady magnetic field.

That is, it is possible to derive the solution of Laplace's equation, which is the fundamental equation of the steady magnetic field and the quasi-steady magnetic field in the free space, using Hᵢ(x, y, 0), which is a Dirichlet-type boundary condition. More specifically, it is possible to derive Hᵢ(x, y, z) at any z-coordinate in a space where no magnetic source exists. That is, it is possible to reconstruct the magnetic field on a reconstruction plane close to marker 105 from the magnetic field on a measurement plane that is an xy plane at z=0.

For example, Hᵢ(x, y, 0) is obtained as the sensing result at the measurement plane at z=0. f(kₓ, k_{y}) is obtained by performing a two-dimensional Fourier transform with respect to x and y on Hᵢ(x, y, 0) obtained from the sensing result. By substituting f(kₓ, k_{y}) obtained by the two-dimensional Fourier transform and z-coordinate value zₐ of the reconstruction plane into Equation (5), Hᵢ(x, y, zₐ) on the reconstruction plane is obtained. This makes it possible to accurately obtain information on the magnetic field in the reconstruction plane.

Ultimately, Hᵢ(x, y, zₐ) on the reconstruction plane is expressed as Equation (6) below.
[Math. 6] ${H}_{i} \left(x, y, {z}_{a}\right) = \frac{1}{{\left(2π\right)}^{2}} ∬ {e}^{{ik}_{x} x + {ik}_{y} y} \left\{f\left({k}_{x}, {k}_{y}\right){e}^{{z}_{a} \sqrt{{{k}_{x}}^{2} + {{k}_{y}}^{2}}}\right\} {dk}_{x} {dk}_{y}$ (6)

Information processing circuit 103 may generate an image expressed by Hᵢ(x, y, zₐ) in the above Equation (6) as the image representing the magnetic field on the reconstruction plane.

In the examples described with reference to FIG. 5 through FIG. 8, one measurement plane is used, but two measurement planes may be used. This will be described in greater detail below with reference to FIG. 9 through FIG. 12.

FIG. 9 is a conceptual diagram illustrating a third example of magnetic sensor array 104 illustrated in FIG. 1. In this example, magnetic sensor array 104 is a combination of a first two-dimensional magnetic sensor array and a second two-dimensional magnetic sensor array, each of which is arranged in the front-rear direction and the left-right direction of vehicle 101.

Each of the first two-dimensional magnetic sensor array and the second two-dimensional magnetic sensor array arranged in the front-rear direction and the left-right direction of vehicle 101 includes a plurality of magnetic sensors 110 arranged in the front-rear direction and the left-right direction of vehicle 101. The position of the first two-dimensional magnetic sensor array and the position of the second two-dimensional magnetic sensor array are different from each other in the up-down direction of vehicle 101.

FIG. 10 is a conceptual diagram illustrating a fourth example of magnetic sensor array 104 illustrated in FIG. 1. In this example, magnetic sensor array 104 is a combination of a first one-dimensional magnetic sensor array and a second one-dimensional magnetic sensor array, each of which is arranged in the left-right direction of vehicle 101.

Each of the first one-dimensional magnetic sensor array and the second one-dimensional magnetic sensor array arranged in the left-right direction of vehicle 101 includes a plurality of magnetic sensors 110 arranged in the left-right direction of vehicle 101. The position of the first one-dimensional magnetic sensor array and the position of the second one-dimensional magnetic sensor array are different from each other in the up-down direction of vehicle 101.

Although the position of the first one-dimensional magnetic sensor array and the position of the second one-dimensional magnetic sensor array in the front-rear direction of vehicle 101 are different from each other in this example, they may coincide with each other.

FIG. 11 is a conceptual diagram illustrating a second example of the reconstruction according to the present embodiment. For example, in the example of FIG. 10, by vehicle 101 traveling, magnetic sensor array 104, which is a combination of two one-dimensional magnetic sensor arrays, can scan two measurement planes above marker 105. This makes it possible to obtain a sensing result of magnetism on two measurement planes. In the example illustrated in FIG. 9 as well, it possible to obtain a sensing result of magnetism on two measurement planes. The speed of vehicle 101 may be used in the examples of FIG. 9 and FIG. 10, similar to the examples of FIG. 5 and FIG. 6.

Information processing circuit 103 generates an image showing the magnetic field in a reconstruction plane closer to marker 105 than the two measurement planes, according to the sensing result of magnetism in the two measurement planes and the fundamental equation of the steady magnetic field and the quasi-steady magnetic field.

FIG. 12 is a conceptual diagram illustrating the coordinate system for the reconstruction illustrated in FIG. 11. FIG. 12 expresses the two measurement planes and the reconstruction plane in an xyz orthogonal coordinate system. As in the example in FIG. 8, z is a coordinate value in the z-direction from the top of vehicle 101 toward the bottom, x is a coordinate value in the x-direction orthogonal to the z-direction, and y is a coordinate value in the y-direction orthogonal to the z-direction and the x-direction. Moreover, the magnetic field is sensed at z=0 and z=d. That is, z=0 and z=d correspond to the two measurement planes.

As described above, the above Equation (1) holds true for Hᵢ(x, y, z), which is the i-component of the magnetic field vector in the xyz orthogonal coordinate system. In addition, the general solution of the above Equation (1) is expressed as the above Equation (2).

In this example, the magnetic sources are assumed to be on both the positive side and the negative side in the z-direction. For example, there may be a marker 105 on the positive side in the z-direction, and a magnetic noise source on the negative side in the z-direction. Accordingly, terms that decay exponentially in the z-direction are not omitted.

For example, the measurement yields i-component Hᵢ(x, y, 0) of the magnetic field vector in the plane of z=0, and the z-direction gradient ∂/∂zHᵢ(x, y, z)|_{z=0} of the i-component of the magnetic field vector. Using these, a(kₓ, k_{y}) and b(kₓ, k_{y}) in Equation (2) can be obtained as illustrated in Equation (7) and Equation (8) below, respectively.
[Math. 7] $a \left({k}_{x}, {k}_{y}\right) = \frac{1}{2} \left(f\left({k}_{x}, {k}_{y}\right)+\frac{g \left({k}_{x}, {k}_{y}\right)}{\sqrt{{{k}_{x}}^{2} + {{k}_{y}}^{2}}}\right)$ (7)
[Math. 8] $b \left({k}_{x}, {k}_{y}\right) = \frac{1}{2} \left(f\left({k}_{x}, {k}_{y}\right)-\frac{g \left({k}_{x}, {k}_{y}\right)}{\sqrt{{{k}_{x}}^{2} + {{k}_{y}}^{2}}}\right)$ (8)

In Equations (7) and (8), f(kₓ, k_{y}) is the two-dimensional Fourier transform image of Hᵢ(x, y, 0), and g(kₓ, k_{y}) is the two-dimensional Fourier transform image of ∂/∂zHᵢ(x, y, z)|_{z=0}. By substituting Equation (7) and Equation (8) into Equation (2), Hᵢ(x, y, z) is obtained as in Equation (9) below.
[Math. 9] $\begin{matrix}{H}_{i} \left(x, y, z\right) \\ = \frac{1}{{\left(2π\right)}^{2}} ∬ {e}^{{ik}_{x} x + {ik}_{y} y} \left\{\begin{matrix}\frac{1}{2} \left(f\left({k}_{x}, {k}_{y}\right)+\frac{g \left({k}_{x}, {k}_{y}\right)}{\sqrt{{{k}_{x}}^{2} + {{k}_{y}}^{2}}}\right) {e}^{z \sqrt{{{k}_{x}}^{2} + {{k}_{y}}^{2}}} \\ + \frac{1}{2} \left(f\left({k}_{x}, {k}_{y}\right)-\frac{g \left({k}_{x}, {k}_{y}\right)}{\sqrt{{{k}_{x}}^{2} + {{k}_{y}}^{2}}}\right) {e}^{- z \sqrt{{{k}_{x}}^{2} + {{k}_{y}}^{2}}}\end{matrix}\right\} {dk}_{x} {dk}_{y}\end{matrix}$ (9)

**As** described above, Equation (9) representing the magnetic field (specifically, the i component of the magnetic field vector) is derived according to the sensing result of the magnetic field and the fundamental equation of the steady magnetic field and the quasi-steady magnetic field in the free space.

That is, using Hᵢ(x, y, 0), which is the Dirichlet-type boundary condition, and ∂/∂zHᵢ(x, y, z)|_{z=0}, which is the Neumann-type boundary condition, it is possible to derive the solution of Laplace's equation, which is the fundamental equation of the steady magnetic field and the quasi-steady magnetic field in the free space. More specifically, it is possible to derive Hᵢ(x, y, z) at any z-coordinate in a space where no magnetic source exists. That is, it is possible to reconstruct the magnetic field on a reconstruction plane close to marker 105 from the magnetic field on a measurement plane that is an xy plane at z=0 and a measurement plane in the vicinity thereof.

For example, Hᵢ(x, y, 0) is obtained as the sensing result at the measurement plane at z=0. ∂/∂zHᵢ(x, y, z)|_{z=0} is calculated according to the sensing results at the two measurement planes. For example, a sensing result at the measurement plane at z=0 and a sensing result at the measurement plane at z=d are obtained, and by dividing their difference by d, which is the distance between these two measurement planes, ∂/∂zHᵢ(x, y, z)|_{z=0} is approximately obtained.

Then, f(kₓ, k_{y}) and g(kₓ, k_{y}) are obtained by performing a two-dimensional Fourier transform with respect to x and y on Hᵢ(x, y, 0) and ∂/∂zHᵢ(x, y, z)|_{z=0} obtained from the sensing results. By substituting f(kₓ, k_{y}) and g(kₓ, k_{y}) obtained by the two-dimensional Fourier transform and z-coordinate value zₐ of the reconstruction plane into Equation (9), Hᵢ(x, y, zₐ) on the reconstruction plane is obtained. This makes it possible to accurately obtain information on the magnetic field in the reconstruction plane.

Ultimately, Hᵢ(x, y, zₐ) on the reconstruction plane is expressed as Equation (10) below.
[Math. 10] $\begin{matrix}{H}_{i} \left(x, y, {z}_{a}\right) \\ = \frac{1}{{\left(2π\right)}^{2}} ∬ {e}^{{ik}_{x} x + {ik}_{y} y} \left\{\begin{matrix}\frac{1}{2} \left(f\left({k}_{x}, {k}_{y}\right)+\frac{g \left({k}_{x}, {k}_{y}\right)}{\sqrt{{{k}_{x}}^{2} + {{k}_{y}}^{2}}}\right) {e}^{{z}_{a} \sqrt{{{k}_{x}}^{2} + {{k}_{y}}^{2}}} \\ + \frac{1}{2} \left(f\left({k}_{x}, {k}_{y}\right)-\frac{g \left({k}_{x}, {k}_{y}\right)}{\sqrt{{{k}_{x}}^{2} + {{k}_{y}}^{2}}}\right) {e}^{- {z}_{a} \sqrt{{{k}_{x}}^{2} + {{k}_{y}}^{2}}}\end{matrix}\right\} {dk}_{x} {dk}_{y}\end{matrix}$ (10)

Information processing circuit 103 may generate an image expressed by Hᵢ(x, y, zₐ) in the above Equation (10) as the image representing the magnetic field on the reconstruction plane.

FIG. 13 is a block diagram illustrating the details of the configuration of autonomous driving control system 102 illustrated in FIG. 1. As described above, autonomous driving control system 102 includes magnetic sensor array 104 and information processing circuit 103.

Autonomous driving control system 102 may further include travel controller 113. Travel controller 113 is a device for driving vehicle 101 and includes a power source, actuators, electric circuits, and the like. For example, information processing circuit 103 may control the travel of vehicle 101 via travel controller 113 by transmitting a control signal for controlling the travel of vehicle 101 to travel controller 113.

Magnetic sensor array 104 includes a plurality of magnetic sensors 110. Information processing circuit 103 includes input circuit 111 and arithmetic circuit 112.

Input circuit 111 is an electric circuit for obtaining information and inputting information to arithmetic circuit 112. For example, input circuit 111 obtains a sensing result of magnetism from magnetic sensor array 104. More specifically, input circuit 111 obtains a sensing result of magnetism from each magnetic sensor 110 included in magnetic sensor array 104. Input circuit 111 inputs the sensing result of magnetism to arithmetic circuit 112.

Input circuit 111 may perform AD conversion (analog-to-digital conversion). For example, input circuit 111 may obtain a sensing result of magnetism from magnetic sensor array 104 as an analog signal. Input circuit 111 may convert the sensing result obtained as an analog signal into a digital signal. Input circuit 111 may input the sensing result converted into a digital signal to arithmetic circuit 112.

Arithmetic circuit 112 is an electric circuit for performing computational processing. For example, arithmetic circuit 112 performs the computational processing described above. More specifically, arithmetic circuit 112 calculates the magnetic field in the reconstruction plane from the magnetic field in the measurement plane, and generates an image showing the magnetic field in the reconstruction plane. Arithmetic circuit 112 may transmit a control signal for controlling the travel of vehicle 101 to travel controller 113 in accordance with the generated image.

FIG. 14 is conceptual diagram illustrating marker 105, a measurement image, and a reconstruction image according to the present embodiment. Marker 105 includes a plurality of magnetic poles comprising one or more N poles and one or more S poles. Magnetic sensor array 104 senses the magnetism of a magnetic field that includes a magnetic field component induced by marker 105. The sensing result is obtained as a measurement image.

However, magnetic sensor array 104 is disposed at a position where it does not collide with the road surface. Magnetic sensor array 104 is therefore spaced from marker 105 provided on the road. The magnetic poles of marker 105 thus do not appear clearly in the measurement image.

Information processing circuit 103 generates, as a reconstruction image, an image showing the magnetic field in a region closer to marker 105 than magnetic sensor array 104, according to the sensing result of magnetism and the fundamental equation of the steady magnetic field and the quasi-steady magnetic field. In such a reconstruction image, the magnetic poles of marker 105 appear clearly. Therefore, information processing circuit 103 can appropriately identify marker 105 according to the reconstruction image.

FIG. 15 is a conceptual diagram illustrating a first example of marker 105. For example, in FIG. 15, the black portion is the N pole portion of marker 105. The white portion is the portion of marker 105 other than the N pole. Stated differently, the white portion is the S pole portion of marker 105, or the portion of marker 105 that is neither the N pole nor the S pole. "N pole" and "S pole" may be switched in this description.

As illustrated in FIG. 15, the magnetic poles of marker 105 may constitute a barcode. Marker 105 may represent a code sequence, via a barcode, for controlling travel of vehicle 101. Accordingly, various information for controlling travel of vehicle 101 can be expressed.

FIG. 16 is a conceptual diagram illustrating a second example of marker 105. For example, just like in the example illustrated in FIG. 15, in FIG. 16, the black portion is the N pole portion of marker 105, and the white portion is the portion of marker 105 other than the N pole. "N pole" and "S pole" may be switched in this description.

As illustrated in FIG. 16, the magnetic poles of marker 105 may constitute a two-dimensional code such as a QR code (registered trademark). Marker 105 may represent a code sequence, via a two-dimensional code, for controlling travel of vehicle 101. Accordingly, a wider variety of information can be expressed.

For example, marker 105 may indicate 4 types of control-travel straight, turn right, turn left, and stop-using 2 bits. One bit may be expressed by one section of the N pole or S pole in marker 105. However, noise may be generated by, for example, manholes and fallen objects. Therefore, marker 105 may represent these controls using a greater number of bits.

Magnetic sensor array 104 is disposed approximately 50 cm away from the road surface (for example, on the underside of an ordinary vehicle) so as not to collide with the road surface. Stated differently, magnetic sensor array 104 is disposed approximately 50 cm away from marker 105. Information processing circuit 103 generates a reconstruction image showing the magnetic field in a reconstruction plane approximately 50 cm below magnetic sensor array 104 in the up-down direction of vehicle 101.

However, as the distance from marker 105 increases, the magnetic field component induced by marker 105 diffuses and the contrast of the measurement image decreases. This may result in the reconstruction image not being appropriately obtained.

Therefore, when magnetic sensor array 104 is approximately 50 cm away from marker 105, in order to obtain appropriate measurement images and reconstruction images, the N pole and S pole in marker 105 should have a width of approximately 10 cm. In other words, one section in the barcode or two-dimensional code of marker 105 should have a width of 10 cm or greater.

For example, the barcode or two-dimensional code of marker 105 has a size corresponding to a value obtained by multiplying the above-mentioned width by the number of bits used to represent the control of vehicle 101.

It is desirable that at least one of the plurality of markers 105 is present underneath vehicle 101 so that vehicle 101 does not deviate from the row of the plurality of markers 105. Therefore, the plurality of markers 105 should be arranged at intervals shorter than the length of vehicle 101 in the front-rear direction of vehicle 101 (for example, 5 m).

In the examples of FIG. 17 through FIG. 22, marker 105 is realised as an electrically conductive wire, in accordance with the statement below that an electric conductor may be used instead of a magnetic material; any realisation of the wire as a ferrite rope or other magnetic material is not encompassed by the wording of the claims and is described only for understanding of the invention. FIG. 17 is a conceptual diagram illustrating a third example of marker 105. In this example, magnetic wire is used as marker 105. For example, the magnetic wire is a ferrite rope and induces a magnetic field component. More specifically, magnetic wire may be provided along the road as marker 105. Information processing circuit 103 may drive vehicle 101 along the road by driving vehicle 101 along the magnetic wire. This appropriately inhibits vehicle 101 from deviating from the road.

FIG. 18 is a conceptual diagram illustrating the magnetic field around the magnetic wire used as marker 105. The magnetic wire is polarized in the width direction of the magnetic wire, with the N pole and S pole straddling the center axis of the magnetic wire.

FIG. 19 shows a reconstruction image in a case where a magnetic wire is used as marker 105. For example, magnetic sensor array 104 is a one-dimensional magnetic sensor array arranged in the arrangement direction illustrated in FIG. 19, and moves in the travel direction illustrated in FIG. 19. The reconstruction image is generated by information processing circuit 103 as an image showing a magnetic field close to marker 105. In the reconstruction image of FIG. 19, the white portion corresponds to the N pole, and the black portion corresponds to the S pole.

As illustrated in the reconstruction image of FIG. 19, a portion corresponding to the N pole of the magnetic wire and a portion corresponding to the S pole of the magnetic wire are observed. In other words, FIG. 19 clearly shows the magnetic field around the magnetic wire used as marker 105 in the reconstruction image. Accordingly, the travel of vehicle 101 is appropriately controlled.

FIG. 20 is a conceptual diagram illustrating a fourth example of marker 105. In this example, a concentric marker 105 is used. Stated differently, marker 105 includes concentric magnetic poles. For example, magnetic wires are arranged in circular shapes with radii of 5 cm, 10 cm, and 15 cm, and are fixed by a support member. As illustrated in FIG. 20, positions where a magnetic wire can be arranged are defined as K, L, and M. The magnetic pattern of marker 105 is determined by where among K, L, and M the magnetic wires are actually arranged.

A magnetic wire may be arranged in one of K, L, or M, may be arranged in two of them, or may be arranged in all three. Stated differently, the possible magnetic wire arrangements are K, L, M, KL, KM, LM, and KLM. In this way, seven magnetic patterns can be used.

FIG. 21 is a conceptual diagram illustrating the magnetic field direction around concentric marker 105. For example, when marker 105 is provided on the road, the magnetic wires are arranged such that the magnetic field direction is oriented upward from marker 105. More specifically, the magnetic wire is arranged such that the N pole is positioned on the upper side.

Note that the magnetic wire may be arranged such that the S pole is positioned on the upper side, or arranged such that the S pole is on the inner side and the N pole is on the outer side, or arranged such that the N pole is on the inner side and the S pole is on the outer side.

For example, the magnetic pattern becomes more easily identifiable if the orientation of K, L, and M is consistent such that one of the N pole or S pole is positioned on the upper side for all of them.

FIG. 22 shows reconstruction images in a case where concentric marker 105 is used. Reconstruction images such as those illustrated in FIG. 22 are generated by information processing circuit 103 for each of the following magnetic wire arrangements: K, L, M, KL, KM, LM, and KLM. In the reconstruction image of FIG. 22, the white portion corresponds to the N pole, and the black portion corresponds to the S pole.

As illustrated in FIG. 22, reconstruction images corresponding to each magnetic pattern are generated. Accordingly, information processing circuit 103 can appropriately identify the magnetic pattern based on the reconstruction image, and can appropriately control the travel of vehicle 101 based on the magnetic pattern. Information processing circuit 103 can appropriately identify the magnetic pattern regardless of the orientation of vehicle 101, and can appropriately read control information such as turn right, turn left, or travel straight indicated by the magnetic pattern.

Here, three circles are used, but two or fewer circles may be used, or four or more circles may be used. The number of circles determines the number of magnetic patterns and the number of types of control.

FIG. 23 is a conceptual diagram illustrating a fifth example of marker 105. In this example, an electric conductor is used as marker 105. For example, the electric conductor used as marker 105 is a closed circuit of a metal such as copper. An annular (ring-shaped) electric conductor may be used as marker 105, or a coil-shaped electric conductor may be used as marker 105.

Marker 105, which is an electric conductor, induces a magnetic field component by electromagnetic induction. Vehicle 101 is equipped with an induction circuit for generating electromagnetic induction.

FIG. 24 is a conceptual diagram illustrating the induction circuit equipped on vehicle 101. As illustrated in FIG. 24, induction circuit 114 equipped on vehicle 101 may be a coil connected to power source 115. Induction circuit 114 equipped on vehicle 101 may include power source 115. Induction circuit 114 may be arranged to cover magnetic sensor array 104 that includes the plurality of magnetic sensors 110.

For example, by current flowing in induction circuit 114, induction circuit 114 induces a downward first magnetic field component underneath vehicle 101. As a result, electromagnetic induction occurs, current flows in marker 105, which is an electric conductor, and marker 105 induces an upward second magnetic field component. Magnetic sensor array 104 senses the magnetism of the magnetic field that includes the second magnetic field component.

This enables autonomous driving control system 102 to sense the magnetism of the magnetic field including the magnetic field component induced by marker 105. Autonomous driving control system 102 can generate an image showing the magnetic field in a region close to marker 105, and appropriately control the travel of vehicle 101 according to the image.

For example, the magnetic poles of permanent magnets such as ferrite magnets may be altered by a strong external magnetic field; a marker that is such a permanent magnet, which is not encompassed by the wording of the claims, would for this reason have a magnetic pattern alterable by a strong external magnetic field. By contrast, because marker 105 is an electric conductor such as copper, magnetism is appropriately controlled by electromagnetic induction, thereby inhibiting adverse effects such as changes in the magnetic pattern.

For example, marker 105, which is an electric conductor, has a magnetic pattern corresponding to the shape of the electric conductor. The plurality of markers 105 may emit steady magnetic fields or quasi-steady magnetic fields with a plurality of magnetic patterns by having a plurality of shapes.

For example, in vehicle 101, information processing circuit 103 of autonomous driving control system 102 may control the operation corresponding to the electric conductor by switching whether or not to apply current to induction circuit 114.

FIG. 25 is a conceptual diagram illustrating another example of the electric conductor used as marker 105. The electric conductor used as marker 105 is not limited to an annular electric conductor, and may be a metal disc or the like. Even when the electric conductor is a metal disc, eddy currents are generated within the metal disc by electromagnetic induction. As a result, a magnetic field component is induced.

More specifically, similar to the example in FIG. 24, for example, a downward first magnetic field component is induced by current flowing in induction circuit 114 of vehicle 101. As a result, electromagnetic induction occurs, eddy currents flow in the metal disc, and the metal disc induces an upward second magnetic field component. Magnetic sensor array 104 senses the magnetism of the magnetic field that includes the second magnetic field component. This enables autonomous driving control system 102 to sense the magnetism of the magnetic field including the magnetic field component induced by the metal disc installed as marker 105.

FIG. 26 is a conceptual diagram illustrating yet another example of the electric conductor used as marker 105. As illustrated in FIG. 26, the electric conductor used as marker 105 may be a coil-shaped closed circuit. Note that the electric conductor used as marker 105 does not need to be connected to a power source, nor does it need to include a power source.

In the plurality of examples of marker 105 illustrated in FIG. 15 through FIG. 22, an electric conductor that is conductive may be used instead of a magnetic material that is magnetic.

For example, in the example illustrated in FIG. 15, there may be a coil in the black portion and no coil in the white portion. Alternatively, in the example illustrated in FIG. 15, there may be no coil in the black portion and a coil in the white portion. Similarly, in the example illustrated in FIG. 16, there may be a coil in the black portion and no coil in the white portion. Alternatively, in the example illustrated in FIG. 16, there may be no coil in the black portion and a coil in the white portion. Even when an electric conductor is used, the control and other aspects explained in FIG. 15 and FIG. 16 can be applied.

FIG. 27 is a conceptual diagram schematically illustrating an example of the electric conductor corresponding to the example in FIG. 15. For example, in the example illustrated in FIG. 15, a closed circuit of an electric conductor as illustrated in FIG. 27 may be arranged along the outline of the black portion (or white portion).

FIG. 28 is a conceptual diagram schematically illustrating an example of the electric conductor corresponding to the example in FIG. 16. For example, in the example illustrated in FIG. 16, a closed circuit of an electric conductor as illustrated in FIG. 28 may be arranged along the outline of the black portion (or white portion).

FIG. 29 is a conceptual diagram schematically illustrating another example of the electric conductor corresponding to the example in FIG. 15. For example, in the example illustrated in FIG. 15, a plate of an electric conductor may be arranged in the black portion (or white portion) as illustrated in FIG. 29. Stated differently, instead of an annular electric conductor as illustrated in FIG. 27, a plate-shaped electric conductor may be used. As described above, even when a plate-shaped electric conductor is used, eddy currents are generated in the electric conductor by electromagnetic induction, and a magnetic field component is induced from the electric conductor. As a result, a barcode-like magnetic pattern is formed.

FIG. 30 is a conceptual diagram schematically illustrating another example of the electric conductor corresponding to the example in FIG. 16. For example, in the example illustrated in FIG. 16, a plate of an electric conductor may be arranged in the black portion (or white portion) as illustrated in FIG. 30. Stated differently, instead of an annular electric conductor as illustrated in FIG. 28, a plate-shaped electric conductor may be used. As described above, even when a plate-shaped electric conductor is used, eddy currents are generated in the electric conductor by electromagnetic induction, and a magnetic field component is induced from the electric conductor. As a result, a two-dimensional code-like magnetic pattern is formed.

Instead of the magnetic wire illustrated in FIG. 17 through FIG. 19, a wire-shaped electric conductor may be used. In this case as well, the control and other aspects explained in FIG. 17 through FIG. 19 can be applied.

Instead of the concentric magnetic material that is magnetic illustrated in FIG. 20 through FIG. 22, a concentric electric conductor may be used. In this case as well, the control and other aspects explained in FIG. 20 through FIG. 22 can be applied.

FIG. 31 is a conceptual diagram illustrating a first specific example of magnetic sensor array 104 illustrated in FIG. 1. In this example, the plurality of magnetic sensors 110 of magnetic sensor array 104 are disposed on two planes that are parallel to both the front-rear direction and the left-right direction of vehicle 101, and correspond to two different positions in the up-down direction of vehicle 101. More specifically, in this example, two two-dimensional magnetic sensor arrays are stacked. This makes it possible to obtain a sensing result of magnetism on two planar measurement planes.

FIG. 32 is a conceptual diagram illustrating a second specific example of magnetic sensor array 104 illustrated in FIG. 1. In this example as well, similar to the example in FIG. 31, the plurality of magnetic sensors 110 of magnetic sensor array 104 are disposed on two planes that are parallel to both the front-rear direction and the left-right direction of vehicle 101, and correspond to two different positions in the up-down direction of vehicle 101. In this example, a plurality of magnetic sensors 110 are arranged alternately on two planes with respect to each of the front-rear direction and the left-right direction of vehicle 101.

This makes it possible to obtain a sensing result of magnetism on two planar measurement planes. In this example, the displacement in the front-rear direction and left-right direction of the plurality of magnetic sensors 110 disposed on the two planes may be ignored. Alternatively, the sensing results may be interpolated by linear interpolation or the like in the front-rear direction and the left-right direction. Alternatively, magnetism may be sensed at corresponding positions across two measurement planes, both in the front-rear and left-right directions by magnetic sensor array 104 moving as vehicle 101 moves.

FIG. 33 is a conceptual diagram illustrating a third specific example of magnetic sensor array 104 illustrated in FIG. 1. In this example as well, similar to the example in FIG. 31, the plurality of magnetic sensors 110 of magnetic sensor array 104 are disposed on two planes that are parallel to both the front-rear direction and the left-right direction of vehicle 101, and correspond to two different positions in the up-down direction of vehicle 101. In this example, a plurality of magnetic sensors 110 are arranged alternately on two planes with respect to the front-rear direction of vehicle 101.

This makes it possible to obtain a sensing result of magnetism on two planar measurement planes. In this example, the displacement in the front-rear direction of the plurality of magnetic sensors 110 disposed on the two planes may be ignored. Alternatively, the sensing results may be interpolated by linear interpolation or the like in the front-rear direction. Alternatively, magnetism may be sensed at corresponding positions across two measurement planes, both in the front-rear and left-right directions by magnetic sensor array 104 moving as vehicle 101 moves.

Note that in this example, a plurality of magnetic sensors 110 are arranged alternately on two planes with respect to the front-rear direction of vehicle 101, but a plurality of magnetic sensors 110 may be arranged alternately on two planes with respect to the left-right direction of vehicle 101. In this case as well, it is possible to obtain a sensing result of magnetism on two planar measurement planes. In this case, the displacement in the left-right direction of the plurality of magnetic sensors 110 disposed on the two planes may be ignored. Alternatively, the sensing results may be interpolated by linear interpolation or the like in the left-right direction.

FIG. 34 is a conceptual diagram illustrating a fourth specific example of magnetic sensor array 104 illustrated in FIG. 1. In this example, the plurality of magnetic sensors 110 of magnetic sensor array 104 are disposed on one plane that is parallel to both the front-rear direction and the left-right direction of vehicle 101. More specifically, in this example, one two-dimensional magnetic sensor array is used. This makes it possible to obtain a sensing result of magnetism on a single planar measurement plane.

Note that magnetic sensor array 104 in this example may sense magnetism in two measurement planes by vibrating in the up-down direction of vehicle 101. An actuator for vibrating magnetic sensor array 104 in the up-down direction of vehicle 101 may be equipped on vehicle 101. Autonomous driving control system 102 may include such an actuator.

FIG. 35 is a conceptual diagram illustrating a fifth specific example of magnetic sensor array 104 illustrated in FIG. 1. In this example, the plurality of magnetic sensors 110 of magnetic sensor array 104 are disposed on two straight lines that are parallel to the left-right direction of vehicle 101 and correspond to two different positions in the up-down direction of vehicle 101. In this example, the two straight lines on which the plurality of magnetic sensors 110 are disposed correspond to the same single position in the front-rear direction of vehicle 101. More specifically, two one-dimensional magnetic sensor arrays are stacked.

As vehicle 101 moves in the front-rear direction, the plurality of magnetic sensors 110 also move. This makes it possible to obtain a sensing result of magnetism on two measurement planes corresponding to two different positions in the up-down direction of vehicle 101.

FIG. 36 is a conceptual diagram illustrating a sixth specific example of magnetic sensor array 104 illustrated in FIG. 1. In this example as well, the plurality of magnetic sensors 110 of magnetic sensor array 104 are disposed on two straight lines that are parallel to the left-right direction of vehicle 101 and correspond to two different positions in the up-down direction of vehicle 101. In this example as well, the two straight lines on which the plurality of magnetic sensors 110 are disposed correspond to the same single position in the front-rear direction of vehicle 101.

In this example, a plurality of magnetic sensors 110 are arranged alternately on two straight lines with respect to the left-right direction of vehicle 101. As vehicle 101 moves in the front-rear direction, the plurality of magnetic sensors 110 also move. This makes it possible to obtain a sensing result of magnetism on two measurement planes corresponding to two different positions in the up-down direction of vehicle 101.

In this example, the displacement in the left-right direction of the plurality of magnetic sensors 110 disposed on the two straight lines may be ignored. Alternatively, the sensing results may be interpolated by linear interpolation or the like in the left-right direction.

FIG. 37 is a conceptual diagram illustrating a seventh specific example of magnetic sensor array 104 illustrated in FIG. 1. In this example as well, the plurality of magnetic sensors 110 of magnetic sensor array 104 are disposed on two straight lines that are parallel to the left-right direction of vehicle 101 and correspond to two different positions in the up-down direction of vehicle 101.

In this example, the two straight lines on which the plurality of magnetic sensors 110 are disposed correspond to two different positions in the front-rear direction of vehicle 101. As vehicle 101 moves in the front-rear direction, the plurality of magnetic sensors 110 also move. This makes it possible to obtain a sensing result of magnetism on two measurement planes corresponding to two different positions in the up-down direction of vehicle 101.

In this example, the displacement in the front-rear direction of the plurality of magnetic sensors 110 disposed on the two straight lines may be ignored. Alternatively, magnetism may be sensed at corresponding positions across two measurement planes, both in the front-rear and left-right direction by magnetic sensor array 104 moving as vehicle 101 moves.

FIG. 38 is a conceptual diagram illustrating an eighth specific example of magnetic sensor array 104 illustrated in FIG. 1. In this example, the plurality of magnetic sensors 110 of magnetic sensor array 104 are disposed on one straight line that is parallel to the left-right direction of vehicle 101. More specifically, in this example, one one-dimensional magnetic sensor array is used. As vehicle 101 moves in the front-rear direction, the plurality of magnetic sensors 110 also move. This makes it possible to obtain a sensing result of magnetism on one measurement plane corresponding to one position in the up-down direction of vehicle 101.

Note that magnetic sensor array 104 in this example may sense magnetism in two measurement planes by vibrating in the up-down direction of vehicle 101. An actuator for vibrating magnetic sensor array 104 in the up-down direction of vehicle 101 may be equipped on vehicle 101. Autonomous driving control system 102 may include such an actuator.

In FIG. 31 through FIG. 38, the up-down direction in each figure corresponds to the up-down direction of vehicle 101, but the up-down direction may be inverted so that magnetic sensor 110 is installed facing downward. In FIG. 31 through FIG. 38, a plurality of magnetic sensors 110 are schematically illustrated, but the configuration of the plurality of magnetic sensors 110 is not limited to the examples illustrated in FIG. 31 through FIG. 38. In particular, the number of the plurality of magnetic sensors 110 is not limited to the number illustrated in FIG. 31 through FIG. 38.

Each magnetic sensor array 104 illustrated in FIG. 31 through FIG. 33 may be considered as a combination of two two-dimensional magnetic sensor arrays arranged in the front-rear direction and the left-right direction of vehicle 101. These two two-dimensional magnetic sensor arrays are disposed at two different positions from each other in the up-down direction of vehicle 101.

Each magnetic sensor array 104 illustrated in FIG. 35 through FIG. 37 may be considered as a combination of two one-dimensional magnetic sensor arrays arranged in the left-right direction of vehicle 101. These two one-dimensional magnetic sensor arrays are disposed at two different positions from each other in the up-down direction of vehicle 101.

FIG. 39 is a conceptual diagram illustrating a magnetic shield equipped on vehicle 101. In a case in which magnetic sensor array 104 does not sense magnetism in the two measurement planes but senses magnetism in one measurement plane, information processing circuit 103 generates the reconstruction image using the above-mentioned Equation (5). However, in this case, there is a possibility that the reconstruction image may not be appropriately generated due to a magnetic noise source above magnetic sensor array 104.

In view of this, as illustrated in FIG. 39, magnetic shield 116 may be provided above magnetic sensor array 104. For example, magnetic shield 116 is made of permalloy, which has a high magnetic permeability. Magnetic shield 116 makes it difficult for magnetism to reach magnetic sensor array 104, which is below magnetic shield 116, from a magnetic noise source above magnetic shield 116. This enables the reconstruction image to be appropriately generated even when a magnetic noise source exists above magnetic sensor array 104.

Magnetic shield 116 is particularly effective in cases in which magnetic sensor array 104 does not sense magnetism in the two measurement planes but senses magnetism in one measurement plane. However, magnetic shield 116 may be used even in cases where magnetic sensor array 104 senses magnetism in the two measurement planes. Autonomous driving control system 102 may include such magnetic shield 116.

FIG. 40 is a flowchart illustrating the travel control process performed by information processing circuit 103. For example, information processing circuit 103 reads a sensing result of magnetism from magnetic sensor array 104 (S201).

Next, information processing circuit 103 generates a reconstruction image in a region close to the estimated position of marker 105, according to the sensing result of magnetism and the fundamental equation of the steady magnetic field and the quasi-steady magnetic field. Information processing circuit 103 then performs correlation between the magnetic patterns prepared in memory and the reconstruction image, and determines whether the correlation value is greater than or equal to a threshold value (S202). If the correlation value is less than the threshold value (No in S202), it is assumed that the magnetism of marker 105 has not been sensed. In such cases, information processing circuit 103 stops vehicle 101 (S207).

If the correlation value is greater than or equal to the threshold value (Yes in S202), it is assumed that the magnetism of marker 105 has been sensed. In such cases, information processing circuit 103 determines where the position corresponding to the correlation value greater than or equal to the threshold value is (S203). Stated differently, information processing circuit 103 determines where the position of the portion in the reconstruction image that yields a correlation value greater than or equal to the threshold value is with respect to the magnetic pattern prepared in memory.

If the position corresponding to the correlation value greater than or equal to the threshold value is the left position, information processing circuit 103 causes vehicle 101 to turn left (S204). If the position corresponding to the correlation value greater than or equal to the threshold value is the center position, information processing circuit 103 causes vehicle 101 to travel straight (S205). If the position corresponding to the correlation value greater than or equal to the threshold value is the right position, information processing circuit 103 causes vehicle 101 to turn right (S206).

Information processing circuit 103 repeats the above-described processing (i.e., the processing from S201 to S207). This enables information processing circuit 103 to control the travel of vehicle 101 according to the reconstruction image.

The above-described travel control process is only one example, and various modifications may be made thereto. For example, the sensing result may be read in advance in a steady magnetic field or a quasi-steady magnetic field. In subsequent operations, a difference from the sensing result of magnetism in the steady magnetic field may be used. With this, the effects of individual differences among the plurality of magnetic sensors 110 and the effects of environmental magnetic fields can be inhibited.

Information processing circuit 103 may control the curvature for causing vehicle 101 to turn left or right according to the position corresponding to the correlation value greater than or equal to the threshold value. For example, information processing circuit 103 may increase the curvature as the position corresponding to the correlation value greater than or equal to the threshold value deviates further from the center. This enables information processing circuit 103 to drive vehicle 101 along various curves.

Information processing circuit 103 may control the travel of vehicle 101 via P control (proportional control). Information processing circuit 103 may use I control (integral control) in curves to drive vehicle 101 smoothly along the curves.

Next, a basic experiment related to the present embodiment will be described with reference to FIG. 41 through FIG. 44. In this basic experiment, a reconstruction image is generated from a measurement image.

FIG. 41 is a conceptual diagram of a basic experiment (an experiment with a reduced scale). FIG. 41 expresses two measurement planes and a reconstruction plane in an xyz orthogonal coordinate system.

z is a coordinate value in the z-direction from the measurement planes toward the magnetic source, x is a coordinate value in the x-direction orthogonal to the z-direction, and y is a coordinate value in the y-direction orthogonal to the z-direction and the x-direction.

The magnetic source includes three ferrite magnets arranged at 2 cm intervals. The reconstruction plane is z = 1.7 mm, which corresponds to the position where the magnetic source is. The two measurement planes are z = 0 mm and z = 0.2 mm, and the magnetic field is sensed at the two measurement planes.

FIG. 42 shows a first measurement image obtained in a basic experiment (an experiment with a reduced scale). More specifically, FIG. 42 illustrates a first measurement image corresponding to the sensing result of magnetism at the measurement plane at z = 0 mm.

FIG. 43 shows a second measurement image obtained in a basic experiment (an experiment with a reduced scale). More specifically, FIG. 43 illustrates a second measurement image corresponding to the sensing result of magnetism at the measurement plane at z = 0.2 mm.

FIG. 44 shows a reconstruction image obtained in a basic experiment (an experiment with a reduced scale). More specifically, FIG. 44 illustrates a reconstruction image showing the magnetic field at the reconstruction plane at z = 1.7 mm. This reconstruction image is generated using Equation (9).

In the first measurement image and the second measurement image illustrated in FIG. 42 and FIG. 43, it is difficult to identify the presence of the three ferrite magnets. However, in the reconstruction image illustrated in FIG. 44, it is possible to identify the presence of the three ferrite magnets. Stated differently, in the reduced-scale experiment, it was demonstrated that the reconstruction image can appropriately show the magnetic field in a region closer to the magnetic source than the measurement plane. Autonomous driving control system 102 can appropriately identify marker 105 by using such a reconstruction image, and can appropriately control the travel of vehicle 101.

Next, verification related to the present embodiment will be described with reference to FIG. 45 through FIG. 48. This verification is a comparative verification between control based on the measurement image and control based on the reconstruction image.

FIG. 45 is a conceptual diagram illustrating the relationship between a measurement image and a reconstruction image for verification. More specifically, FIG. 45 illustrates the magnetic field distribution on the surface of marker 105, the measurement image showing the sensing result of magnetism in magnetic sensor array 104, and the reconstruction image obtained as an image showing the magnetic field in a region close to marker 105 generated by information processing circuit 103.

The measurement image corresponds to the sensing result of magnetism in magnetic sensor array 104 spaced from marker 105, and therefore deviates from the magnetic field distribution on the surface of marker 105. However, the reconstruction image is an image obtained according to fundamental equation of steady magnetic fields and quasi-steady magnetic fields, and shows the magnetic field in a region close to marker 105 on the road where marker 105 is provided. Therefore, it approximates the magnetic field distribution on the surface of marker 105. Stated differently, the reconstruction image appropriately shows the magnetic pattern of marker 105.

Therefore, it is assumed that autonomous driving control system 102 can more appropriately control the travel of vehicle 101 by using the reconstruction image rather than using the measurement image.

For comparative verification between control based on the measurement image and control based on the reconstruction image, a prototype model of vehicle 101 equipped with autonomous driving control system 102, and a plurality of markers 105 are used in an indoor environment. In the indoor environment, a plurality of tracking target markers, each being marker 105 implemented as a tracking target, and a plurality of dummy markers, each being marker 105 implemented as a dummy marker, are arranged.

For both control based on the measurement image and control based on the reconstruction image, it is verified whether vehicle 101 can continuously track only the plurality of tracking target markers among the plurality of markers 105.

FIG. 46 is a conceptual diagram illustrating a tracking target marker. The tracking target marker has a two-dimensional code-like magnetic pattern. Stated differently, the tracking target marker has a matrix-like magnetic pattern, and each of the plurality of sections included in the magnetic pattern corresponds to an N pole, an S pole, or a non-magnetic pole that is neither an N pole nor an S pole.

FIG. 47 is a conceptual diagram illustrating dummy markers. As illustrated in FIG. 47, four types of dummy markers are used for verification.

The dummy marker, similar to the tracking target marker, has a matrix-like magnetic pattern, and each of the plurality of sections included in the magnetic pattern corresponds to an N pole, an S pole, or a non-magnetic pole. The four types of dummy markers have four mutually different types of magnetic patterns. The four types of magnetic patterns of the four types of dummy markers are also different from the magnetic pattern of the tracking target marker.

FIG. 48 is a graph illustrating comparative verification results between control based on the measurement image and control based on the reconstruction image. In FIG. 48, the recognition error is the difference between the position of the tracking target marker recognized by autonomous driving control system 102 and the actual position of the tracking target marker. In control based on the measurement image, the recognition error is relatively large, and vehicle 101 becomes unable to track the tracking target marker partway through. However, in control based on the reconstruction image, the recognition error is relatively small, and vehicle 101 is able to continuously track the tracking target marker until the end.

Stated differently, autonomous driving control system 102 can more appropriately control the travel of vehicle 101 by using the reconstruction image rather than using the measurement image.

As described above, autonomous driving control system 102 of vehicle 101 that travels on road provided with markers 105 includes magnetic sensor array 104 and information processing circuit 103. Magnetic sensor array 104 is equipped on vehicle 101 and senses magnetism. Information processing circuit 103 generates an image showing the magnetic field in a region closer to marker 105 than magnetic sensor array 104, according to the sensing result of magnetism and the fundamental equation of the steady magnetic field and the quasi-steady magnetic field. Information processing circuit 103 controls the travel of vehicle 101 in accordance with the image.

This enables autonomous driving control system 102 to control the travel of vehicle 101 according to an image showing the magnetic field in a region closer to marker 105 than magnetic sensor array 104. This image is assumed to show marker 105 with high accuracy. It is therefore assumed that marker 105 can be appropriately identified. Therefore, autonomous driving control system 102 can appropriately control the travel of vehicle 101 according to marker 105.

For example, information processing circuit 103 may obtain the speed of vehicle 101. Information processing circuit 103 may convert temporal changes in the sensing result into spatial changes according to the speed. Information processing circuit 103 may generate an image showing the magnetic field according to the fundamental equation and the sensing result in which the temporal changes have been converted into the spatial changes.

Accordingly, autonomous driving control system 102 can sufficiently obtain the spatial change of the magnetic field according to the temporal changes in sensing results and the speed of vehicle 101. Therefore, autonomous driving control system 102 can adequately generate an image showing the magnetic field.

For example, magnetic sensor array 104 may include one or more two-dimensional magnetic sensor arrays arranged in the front-rear direction and the left-right direction of vehicle 101. Accordingly, autonomous driving control system 102 can sufficiently obtain the spatial change of the magnetic field with a two-dimensional magnetic sensor array. Therefore, autonomous driving control system 102 can adequately generate an image showing the magnetic field.

For example, magnetic sensor array 104 may include one or more one-dimensional magnetic sensor arrays arranged in the left-right direction of vehicle 101. This enables autonomous driving control system 102 to appropriately control the travel of vehicle 101 with few resources and at low cost.

For example, magnetic sensor array 104 may sense magnetism in one layer arranged in the front-rear direction and the left-right direction of vehicle 101. This enables autonomous driving control system 102 to sense magnetism in a simple manner and perform processing with a low computational load.

For example, magnetic sensor array 104 may sense magnetism in two layers arranged in the front-rear direction and the left-right direction of vehicle 101. This enables autonomous driving control system 102 to appropriately obtain the gradient of the magnetic field in the up-down direction and adequately generate an image showing the magnetic field.

For example, information processing circuit 103 may generate the image according to the above Equation (5) as an arithmetic expression which is in accordance with the sensing result and the fundamental equation.

In Equation (5) above, Hᵢ(x, y, z) represents the i component of the magnetic field at coordinate position (x, y, z). i indicates x, y, or z. z is a coordinate value in the z-direction from the top of vehicle 101 toward bottom. x is a coordinate value in the x-direction orthogonal to the z-direction. y is a coordinate value in the y-direction orthogonal to the z-direction and the x-direction.

f(kₓ, k_{y}) represents the two-dimensional Fourier transform image of Hᵢ(x, y, 0). Hᵢ(x, y, 0) represents the sensing result at the measurement plane (x, y, 0). kₓ is a wavenumber with respect to x. k_{y} is a wavenumber with respect to y.

This enables autonomous driving control system 102 to adequately generate an image showing the magnetic field in a region closer to marker 105 than magnetic sensor array 104, using the sensing result.

For example, information processing circuit 103 may generate the image according to the above Equation (9) as an arithmetic expression which is in accordance with the sensing result and the fundamental equation.

In Equation (9) above, Hᵢ(x, y, z) represents the i component of the magnetic field at coordinate position (x, y, z). i indicates x, y, or z. z is a coordinate value in the z-direction from the top of vehicle 101 toward bottom. x is a coordinate value in the x-direction orthogonal to the z-direction. y is a coordinate value in the y-direction orthogonal to the z-direction and the x-direction.

f(kₓ, k_{y}) represents the two-dimensional Fourier transform image of Hᵢ(x, y, 0). Hᵢ(x, y, 0) represents the sensing result at the measurement plane (x, y, 0). g(kₓ, k_{y}) represents the two-dimensional Fourier transform image of ∂/∂zHᵢ(x, y, z)|_{z=0}. ∂/∂zHᵢ(x, y, z)|_{z=0} represents the gradient in the z-direction of the sensing result at the measurement plane (x, y, 0). kₓ is a wavenumber with respect to x. k_{y} is a wavenumber with respect to y.

This enables autonomous driving control system 102 to adequately generate an image showing the magnetic field in a region closer to marker 105 than magnetic sensor array 104, using the sensing result and its gradient.

For example, autonomous driving control system 102 may further include at least one of a camera, a LiDAR, a millimeter-wave radar, an ultrasonic sonar, or a GPS receiver. Here, the at least one of the camera, the LiDAR, the millimeter-wave radar, the ultrasonic sonar, or the GPS receiver is equipped on vehicle 101. Information processing circuit 103 may further control the travel of vehicle 101 according to the at least one of the camera, the LiDAR, the millimeter-wave radar, the ultrasonic sonar, or the GPS receiver.

This enables autonomous driving control system 102 to control the travel of vehicle 101 according to various information obtained from a camera, a LiDAR, a millimeter-wave radar, an ultrasonic sonar, and a GPS receiver.

Autonomous driving control system 102 may further include, for example, marker 105 provided on the road. This enables autonomous driving control system 102 to control the travel of vehicle 101 according to marker 105 included in autonomous driving control system 102.

Autonomous driving control system 102 may further include, for example, a plurality of markers 105 each provided on the road as marker 105. The plurality of markers 105 may emit steady magnetic fields or quasi-steady magnetic fields with a plurality of magnetic patterns for controlling the travel of vehicle 101. This enables autonomous driving control system 102 to control the travel of vehicle 101 according to a plurality of magnetic patterns.

For example, each of the plurality of magnetic patterns may be a concentric magnetic pattern. This enables autonomous driving control system 102 to inhibit the influence of the orientation of vehicle 101 in the identification of magnetic patterns.

For example, each of the plurality of magnetic patterns may be a barcode-like magnetic pattern. This enables autonomous driving control system 102 to control the travel of vehicle 101 according to a barcode that can simply indicate various information.

For example, each of the plurality of magnetic patterns may be a two-dimensional code-like magnetic pattern. This enables autonomous driving control system 102 to control the travel of vehicle 101 according to a two-dimensional code that can indicate a greater variety of information.

For example, marker 105 may represent a code sequence, as an arrangement of a plurality of magnetic poles, for controlling travel of vehicle 101. The code sequence may include a code for error detection. Information processing circuit 103 may read out the code sequence in accordance with the image showing the magnetic field.

Furthermore, information processing circuit 103 may determine whether the read-out code sequence includes an error according to the code included in the read-out code sequence. Information processing circuit 103 may control the travel of vehicle 101 in accordance with the read-out code sequence if it is determined that no error is included in the read-out code sequence.

This enables autonomous driving control system 102 to read a code sequence from marker 105 via an image indicating the magnetic field. Autonomous driving control system 102 can determine whether the read-out code sequence includes an error according to the code for error detection. Accordingly, autonomous driving control system 102 can appropriately control the travel of vehicle 101 according to a highly reliable code sequence.

For example, marker 105 may have a wire-like shape. This enables autonomous driving control system 102 to control the travel of vehicle 101 along a wire-like shape.

For example, marker 105 may be a magnetic material that is magnetic. This enables autonomous driving control system 102 to control the travel of vehicle 101 using a simple marker 105.

For example, marker 105 may be an electric conductor that is conductive. This enables autonomous driving control system 102 to appropriately control the travel of vehicle 101 using electric conductors as marker 105.

Autonomous driving control system 102 may further include, for example, induction circuit 114. Here, induction circuit 114 is equipped on vehicle 101 and induces a first magnetic field component. Marker 105 may induce a second magnetic field component in response to the first magnetic field component. This enables autonomous driving control system 102 to appropriately generate a magnetic field from marker 105 even when an electric conductor is used as marker 105.

For example, vehicle 101 according to one aspect of the present disclosure may include autonomous driving control system 102. This enables vehicle 101 to control the travel of vehicle 101 according to an image showing the magnetic field in a region closer to marker 105 than magnetic sensor array 104.

Hereinbefore, an aspect of the autonomous driving control system has been described according to an embodiment, but aspects of the autonomous driving control system are not limited to this embodiment. Any modification within the scope of the claims conceivable by those skilled in the art may be made to the embodiment, and a plurality of elements according to the embodiment may be combined arbitrarily.

For example, processing that is executed by a specific element according to the embodiment may be executed by a different element, instead of the specific element. Moreover, a sequence of a plurality of processes may be changed, or a plurality of processes may be executed in parallel. A plurality of variations may also be applied in combination. The ordinal numbers used in the description, such as first, second, etc., may be replaced as appropriate. The ordinal number may be given anew to or removed from element names, etc.

The autonomous driving control method including steps executed by each element of the autonomous driving control system may be executed by any arbitrary device or system. For example, part or all of the autonomous driving control method may be executed by a computer that includes, for example, a processor, memory, and an input/output circuit. At this time, a program for causing the computer to execute the autonomous driving control method may be executed by the computer to execute the autonomous driving control method.

The above-described program may be recorded on a non-transitory computer-readable recording medium.

Each of the elements of the autonomous driving control system may be configured in the form of dedicated hardware, in the form of general-purpose hardware that executes the above program or the like, or any combination thereof. The general-purpose hardware may be configured by, for example, memory that records the program and a general-purpose processor that reads out and executes the program from the memory. The memory as used herein may, for example, be semiconductor memory or a hard disk, and the general-purpose processor may, for example, be a CPU.

The dedicated hardware may be configured by, for example, memory and a dedicated processor. For example, a dedicated processor may refer to a memory for recording data and execute the autonomous driving control method described above.

Each element of the autonomous driving control system may be an electric circuit. These electric circuits may be configured collectively as a single electric circuit, or configured individually as different electric circuits. These electric circuits may correspond to dedicated hardware or general-purpose hardware that executes the above-described program or the like.

The autonomous driving control system can also be described as an autonomous driving control device. The autonomous driving control system may be configured from a plurality of dispersed devices.

### [Industrial Applicability]

One aspect of the present disclosure is useful for an autonomous driving control system of a vehicle that travels on a road provided with markers, and is applicable in, for example, traffic systems and transportation systems.

### [Reference Signs List]

- 101: vehicle
- 102: autonomous driving control system
- 103: information processing circuit
- 104: magnetic sensor array
- 105: marker
- 106: camera
- 107: LiDAR
- 108: wave sensor
- 109: GPS receiver
- 110: magnetic sensor
- 111: input circuit
- 112: arithmetic circuit
- 113: travel controller
- 114: induction circuit
- 115: power source
- 116: magnetic shield
- 117: protective agent

## Claims

1. An autonomous driving control system (102) for a vehicle (101) that travels on a road provided with a marker (105) that emits a steady magnetic field or a quasi-steady magnetic field, the autonomous driving control system (102) comprising:
a magnetic sensor array (104) that is equipped on the vehicle (101) and is adapted to sense magnetism;
the marker (105) provided on the road; and
an induction circuit (114) that is equipped on the vehicle (101) and is adapted to induce a first magnetic field component, **characterized in that** it further comprises
an information processing circuit (103) that is adapted to generate an image showing a magnetic field in a region closer to the marker (105) than the magnetic sensor array (104), according to a sensing result of the magnetism and a fundamental equation of the steady magnetic field and the quasi-steady magnetic field, and is adapted to control travel of the vehicle (101) according to the image; and **in that**
the marker (105) is an electric conductor that is conductive and is adapted to emit the steady magnetic field or the quasi-steady magnetic field by inducing a second magnetic field component in response to the first magnetic field component.

2. The autonomous driving control system (102) according to claim 1, wherein
the information processing circuit (103):
is adapted to obtain a speed of the vehicle (101);
is adapted to convert temporal changes in the sensing result into spatial changes according to the speed; and
is adapted to generate the image according to the fundamental equation and the sensing result in which the temporal changes have been converted into the spatial changes.

3. The autonomous driving control system (102) according to claim 1 or 2, wherein
the magnetic sensor array (104) includes one or more two-dimensional magnetic sensor arrays arranged in a front-rear direction and a left-right direction of the vehicle (101).

4. The autonomous driving control system (102) according to claim 1 or 2, wherein
the magnetic sensor array (104) includes one or more one-dimensional magnetic sensor arrays arranged in a left-right direction of the vehicle (101).

5. The autonomous driving control system (102) according to claim 1 or 2, wherein
the magnetic sensor array (104) is adapted to sense the magnetism in one layer arranged in a front-rear direction and a left-right direction of the vehicle (101).

6. The autonomous driving control system (102) according to claim 1 or 2, wherein
the magnetic sensor array (104) is adapted to sense the magnetism in two layers arranged in a front-rear direction and a left-right direction of the vehicle (101).

7. The autonomous driving control system (102) according to claim 1 or 2, wherein
the information processing circuit (103) is adapted to generate the image according to the following arithmetic expression which is in accordance with the sensing result and the fundamental equation: [Math. 1] ${H}_{i} \left(x, y, z\right) = \frac{1}{{\left(2π\right)}^{2}} ∬ {e}^{{ik}_{x} x + {ik}_{y} y} \left\{f\left({k}_{x}{, k}_{y}\right){e}^{z \sqrt{{{k}_{x}}^{2} + {{k}_{y}}^{2}}}\right\} {dk}_{x} {dk}_{y}$
where: Hᵢ(x, y, z) is an i component in a magnetic field at a coordinate position (x, y, z); i is x, y, or z; z is a coordinate value in a z-direction from a top of the vehicle (101) toward a bottom of the vehicle (101); x is a coordinate value in an x-direction orthogonal to the z-direction, y is a coordinate value in a y-direction orthogonal to the z-direction and the x-direction, f(kₓ, k_{y}) is a two-dimensional Fourier transform image of Hᵢ(x, y, 0) indicating the sensing result at (x, y, 0) which is a measurement plane; kₓ is a wavenumber with respect to x, and k_{y} is a wavenumber with respect to y.

8. The autonomous driving control system (102) according to claim 1 or 2, wherein
the information processing circuit (103) is adapted to generate the image according to the following arithmetic expression which is in accordance with the sensing result and the fundamental equation: [Math. 2] $\begin{matrix}{H}_{i} \left(x, y, z\right) \\ = \frac{1}{{\left(2π\right)}^{2}} ∬ {e}^{{ik}_{x} x + {ik}_{y} y} \left\{\begin{matrix}\frac{1}{2} \left(f\left({k}_{x}{, k}_{y}\right)+\frac{g \left({k}_{x}{, k}_{y}\right)}{\sqrt{{{k}_{x}}^{2} + {{k}_{y}}^{2}}}\right) {e}^{z \sqrt{{{k}_{x}}^{2} + {{k}_{y}}^{2}}} \\ + \frac{1}{2} \left(f\left({k}_{x}{, k}_{y}\right)-\frac{g \left({k}_{x}{, k}_{y}\right)}{\sqrt{{{k}_{x}}^{2} + {{k}_{y}}^{2}}}\right) {e}^{- z \sqrt{{{k}_{x}}^{2} + {{k}_{y}}^{2}}}\end{matrix}\right\} {dk}_{x} {dk}_{y}\end{matrix}$
where: Hᵢ(x, y, z) is an i component in a magnetic field at a coordinate position (x, y, z); i is x, y, or z; z is a coordinate value in a z-direction from a top of the vehicle (101) toward a bottom of the vehicle (101); x is a coordinate value in an x-direction orthogonal to the z-direction, y is a coordinate value in a y-direction orthogonal to the z-direction and the x-direction, f(kₓ, k_{y}) is a two-dimensional Fourier transform image of Hᵢ(x, y, 0) indicating the sensing result at (x, y, 0) which is a measurement plane; g(kₓ, k_{y}) is a two-dimensional Fourier transform image of ∂/∂zHᵢ(x, y, z)|_{z=0} indicating a gradient in the z-direction of the sensing result at (x, y, 0) which is the measurement plane; kₓ is a wavenumber with respect to x, and k_{y} is a wavenumber with respect to y.

9. The autonomous driving control system (102) according to claim 1 or 2, further comprising:
at least one of a camera, a LiDAR (107), a millimeter-wave radar (108), an ultrasonic sonar, or a GPS receiver (109) equipped on the vehicle (101), wherein
the information processing circuit (103) is further adapted to control the travel of the vehicle (101) according to the at least one of the camera, the LiDAR (107), the millimeter-wave radar (108), the ultrasonic sonar, or the GPS receiver (109).

10. The autonomous driving control system (102) according to claim 1 or 2, wherein
the marker (105) comprises a plurality of markers provided on the road, and
the plurality of markers are adapted to emit steady magnetic fields or quasi-steady magnetic fields with a plurality of magnetic patterns for controlling the travel of the vehicle (101).

11. The autonomous driving control system (102) according to claim 10, wherein
each of the plurality of magnetic patterns is a concentric magnetic pattern.

12. The autonomous driving control system (102) according to claim 10, wherein
each of the plurality of magnetic patterns is a barcode-like magnetic pattern.

13. The autonomous driving control system (102) according to claim 10, wherein
each of the plurality of magnetic patterns is a two-dimensional code-like magnetic pattern.

14. The autonomous driving control system (102) according to claim 1 or 2, wherein
the marker (105) represents a code sequence, as an arrangement of a plurality of magnetic poles, for controlling the travel of the vehicle (101),
the code sequence includes a code for error detection, and
the information processing circuit (103):
is adapted to read the code sequence according to the image;
is adapted to determine whether the code sequence read includes an error according to the code included in the code sequence read; and
is adapted to control the travel of the vehicle (101) in accordance with the code sequence read on condition that the code sequence read is determined to include no error.

15. The autonomous driving control system (102) according to claim 1 or 2, wherein
the marker (105) has a wire-like shape.

16. An autonomous driving control method for a vehicle (101) that travels on a road provided with a marker (105) that emits a steady magnetic field or a quasi-steady magnetic field, the autonomous driving control method comprising:
sensing magnetism by a magnetic sensor array (104) equipped on the vehicle (101); and
generating an image showing a magnetic field in a region closer to the marker (105) than the magnetic sensor array (104), according to a sensing result of the magnetism and a fundamental equation of the steady magnetic field and the quasi-steady magnetic field, and controlling travel of the vehicle (101) according to the image; and
inducing a first magnetic field component by an induction circuit (114) equipped on the vehicle (101), wherein
the marker (105) is an electric conductor that is conductive and emits the steady magnetic field or the quasi-steady magnetic field by inducing a second magnetic field component in response to the first magnetic field component.

## Patentansprüche

1. System (102) zur Steuerung autonomen Fahrens für ein Fahrzeug (101), das auf einer Straße fährt, die mit einer Markierung (105) versehen ist, die ein stationäres Magnetfeld oder ein quasistationäres Magnetfeld emittiert, wobei das System (102) zur Steuerung autonomen Fahrens Folgendes umfasst:
ein Magnetsensorarray (104), das auf dem Fahrzeug (101) eingerichtet und dazu ausgelegt ist, Magnetismus zu erfassen;
die Markierung (105), die auf der Straße vorgesehen ist; und
eine Induktionsschaltung (114), die auf dem Fahrzeug (101) eingerichtet und dazu ausgelegt ist, eine erste Magnetfeldkomponente zu induzieren, **dadurch gekennzeichnet, dass** es ferner Folgendes umfasst:
eine Informationsverarbeitungsschaltung (103), die dazu ausgelegt ist, ein Bild, das ein Magnetfeld in einer Region näher zu der Markierung (105) als dem Magnetsensorarray (104) darstellt, gemäß einem Erfassungsergebnis des Magnetismus und einer Fundamentalgleichung des stationären Magnetfelds und des quasistationären Magnetfelds zu erzeugen, und dazu ausgelegt ist, die Fahrt des Fahrzeugs (101) gemäß dem Bild zu steuern; und dadurch, dass
die Markierung (105) ein elektrischer Leiter ist, der leitend und dazu ausgelegt ist, das stationäre Magnetfeld oder das quasistationäre Magnetfeld zu emittieren, indem er eine zweite Magnetfeldkomponente in Reaktion auf die erste Magnetfeldkomponente induziert.

2. System (102) zur Steuerung autonomen Fahrens nach Anspruch 1, wobei
die Informationsverarbeitungseinrichtung (103)
dazu ausgelegt ist, eine Geschwindigkeit des Fahrzeugs (101) abzurufen;
dazu ausgelegt ist, zeitliche Änderungen des Erfassungsergebnisses gemäß der Geschwindigkeit in räumliche Änderungen umzuwandeln; und
dazu ausgelegt ist, das Bild gemäß der Fundamentalgleichung und dem Erfassungsergebnis zu erzeugen, in dem die zeitlichen Änderungen in die räumlichen Änderungen umgewandelt wurden.

3. System (102) zur Steuerung autonomen Fahrens nach Anspruch 1 oder 2, wobei
das Magnetsensorarray (104) ein oder mehrere zweidimensionale Magnetsensorarrays umfasst, die in einer Vorwärts-Rückwärts-Richtung und einer Links-Rechts-Richtung des Fahrzeugs (101) angeordnet sind.

4. Steuersystem (102) für autonomes Fahren nach Anspruch 1 oder 2, wobei
das Magnetsensorarray (104) ein oder mehrere zweidimensionale Magnetsensorarrays umfasst, die in einer Links-Rechts-Richtung des Fahrzeugs (101) angeordnet sind.

5. System (102) zur Steuerung autonomen Fahrens nach Anspruch 1 oder 2, wobei
das Magnetsensorarray (104) dazu ausgelegt ist, den Magnetismus in einer Schicht zu erfassen, die in einer Vorwärts-Rückwärts-Richtung und einer Links-Rechts-Richtung des Fahrzeugs (101) angeordnet ist.

6. System (102) zur Steuerung autonomen Fahrens nach Anspruch 1 oder 2, wobei
das Magnetsensorarray (104) dazu ausgelegt ist, den Magnetismus in zwei Schichten zu erfassen, die in einer Vorwärts-Rückwärts-Richtung und einer Links-Rechts-Richtung des Fahrzeugs (101) angeordnet sind.

7. System (102) zur Steuerung autonomen Fahrens nach Anspruch 1 oder 2, wobei
die Informationsverarbeitungsschaltung (103) dazu ausgelegt ist, das Bild gemäß dem folgenden arithmetischen Ausdruck zu erzeugen, der dem Erfassungsergebnis und der Fundamentalgleichung entspricht: [Math. 1] ${H}_{i} \left(x, y, z\right) = \frac{1}{{\left(2π\right)}^{2}} ∬ {e}^{{ik}_{x} x + {ik}_{y} y} \left\{f\left({k}_{x}{, k}_{y}\right){e}^{z \sqrt{{{k}_{x}}^{2} + {{k}_{y}}^{2}}}\right\} {dk}_{x} {dk}_{y}$
wobei: Hᵢ(x, y, z) eine i-Komponente in einem Magnetfeld an einer Koordinatenposition (x, y, z) ist; i x, y oder z ist; z ein Koordinatenwert in einer z-Richtung von der Oberseite des Fahrzeugs (101) zu einer Unterseite des Fahrzeugs (101) ist; x ein Koordinatenwert in einer x-Richtung orthogonal zu der z-Richtung ist, y ein Koordinatenwert in einer y-Richtung orthogonal zu der z-Richtung und der x-Richtung ist, f(kₓ, k_{y}) ein Bild einer zweidimensionalen Fourier-Transformation von Hᵢ(x, y, 0) ist, das ein Erfassungsergebnis bei (x, y, 0) anzeigt, wobei es sich um eine Messebene handelt; kₓ eine Wellenzahl in Bezug auf x ist und k_{y} eine Wellenzahl in Bezug auf y ist.

8. System (102) zur Steuerung autonomen Fahrens nach Anspruch 1 oder 2, wobei
die Informationsverarbeitungsschaltung (103) dazu ausgelegt ist, das Bild gemäß dem folgenden arithmetischen Ausdruck zu erzeugen, der dem Erfassungsergebnis und der Fundamentalgleichung entspricht: [Math. 2] $\begin{matrix}{H}_{i} \left(x, y, z\right) \\ = \frac{1}{{\left(2π\right)}^{2}} ∬ {e}^{{ik}_{x} x + {ik}_{y} y} \left\{\begin{matrix}\frac{1}{2} \left(f\left({k}_{x}{, k}_{y}\right)+\frac{g \left({k}_{x}{, k}_{y}\right)}{\sqrt{{{k}_{x}}^{2} + {{k}_{y}}^{2}}}\right) {e}^{z \sqrt{{{k}_{x}}^{2} + {{k}_{y}}^{2}}} \\ + \frac{1}{2} \left(f\left({k}_{x}{, k}_{y}\right)-\frac{g \left({k}_{x}{, k}_{y}\right)}{\sqrt{{{k}_{x}}^{2} + {{k}_{y}}^{2}}}\right) {e}^{- z \sqrt{{{k}_{x}}^{2} + {{k}_{y}}^{2}}}\end{matrix}\right\} {dk}_{x} {dk}_{y}\end{matrix}$
wobei: Hᵢ(x, y, z) eine i-Komponente in einem Magnetfeld an einer Koordinatenposition (x, y, z) ist; i x, y oder z ist; z ein Koordinatenwert in einer z-Richtung von der Oberseite des Fahrzeugs (101) zu einer Unterseite des Fahrzeugs (101) ist; x ein Koordinatenwert in einer x-Richtung orthogonal zu der z-Richtung ist, y ein Koordinatenwert in einer y-Richtung orthogonal zu der z-Richtung und der x-Richtung ist, f(kₓ, k_{y}) ein Bild einer zweidimensionalen Fourier-Transformation von Hᵢ(x, y, 0) ist, das ein Erfassungsergebnis bei (x, y, 0) anzeigt, wobei es sich um eine Messebene handelt; g(kₓ, k_{y}) ein Bild einer zweidimensionalen Fourier-Transformation von ∂/∂zHᵢ(x, y, z)|_{z=0} ist, das einen Gradienten in der z-Richtung des Erfassungsergebnisses bei (x, y, 0) anzeigt, wobei es sich um die Messebene handelt; kₓ eine Wellenzahl in Bezug auf x ist und k_{y} eine Wellenzahl in Bezug auf y ist.

9. System (102) zur Steuerung autonomen Fahrens nach Anspruch 1 oder 2, ferner umfassend:
mindestens eines von einer Kamera, einem LiDAR (107), einem Millimeterwellenradar (108), einem Ultraschallsonar oder einem GPS-Empfänger (109), das auf dem Fahrzeug (101) eingerichtet ist; wobei
die Informationsverarbeitungsvorrichtung (103) ferner dazu ausgelegt ist, die Fahrt des Fahrzeugs (101) gemäß dem mindestens einen von der Kamera, dem LiDAR (107), dem Millimeterwellenradar (108), dem Ultraschallsonar oder dem GPS-Empfänger (109) zu steuern.

10. System (102) zur Steuerung autonomen Fahrens nach Anspruch 1 oder 2, wobei
die Markierung (105) eine Mehrzahl von Markierungen umfasst, die auf der Straße vorgesehen sind; und
die Mehrzahl von Markierungen dazu ausgelegt ist, stationäre Magnetfelder oder quasistationäre Magnetfelder mit einer Mehrzahl von magnetischen Mustern zum Steuern der Fahrt des Fahrzeugs (101) zu emittieren.

11. System (102) zur Steuerung autonomen Fahrens nach Anspruch 10, wobei
jedes der Mehrzahl von magnetischen Mustern ein konzentrisches magnetisches Muster ist.

12. System (102) zur Steuerung autonomen Fahrens nach Anspruch 10, wobei
jedes der Mehrzahl von magnetischen Mustern ein strichcodeartiges magnetisches Muster ist.

13. System (102) zur Steuerung autonomen Fahrens nach Anspruch 10, wobei
jedes der Mehrzahl von magnetischen Mustern ein zweidimensionales codeartiges magnetisches Muster ist.

14. System (102) zur Steuerung autonomen Fahrens nach Anspruch 1 oder 2, wobei
die Markierung (105) eine Codefolge als eine Anordnung einer Mehrzahl von magnetischen Polen zum Steuern der Fahrt des Fahrzeugs (101) darstellt,
die Codefolge einen Code zur Fehlererkennung aufweist und
die Informationsverarbeitungseinrichtung (103)
dazu ausgelegt ist, die Codefolge gemäß dem Bild zu lesen;
dazu ausgelegt ist, gemäß dem in der gelesenen Codefolge enthaltenen Code zu bestimmen, ob die Codefolge einen Fehler enthält,
dazu ausgelegt ist, die Fahrt des Fahrzeugs (101) unter der Bedingung, dass bestimmt wird, dass die gelesene Codefolge keinen Fehler enthält, gemäß der gelesenen Codefolge zu steuern.

15. System (102) zur Steuerung autonomen Fahrens nach Anspruch 1 oder 2, wobei
die Markierung (105) eine drahtartige Form aufweist.

16. Verfahren zur Steuerung autonomen Fahrens für ein Fahrzeug (101), das auf einer Straße fährt, die mit einer Markierung (105) versehen ist, die ein stationäres Magnetfeld oder ein quasistationäres Magnetfeld emittiert, wobei das Steuerverfahren für autonomes Fahren Folgendes umfasst:
Erfassen von Magnetismus durch ein Magnetsensorarray (104), das auf dem Fahrzeug (101) eingerichtet ist; und
Erzeugen eines Bildes, das ein Magnetfeld in einer Region näher zu der Markierung (105) als dem Magnetsensorarray (104) darstellt, gemäß einem Erfassungsergebnis des Magnetismus und einer Fundamentalgleichung des stationären Magnetfelds und des quasistationären Magnetfelds und Steuern der Fahrt des Fahrzeugs (101) gemäß dem Bild; und
Induzieren einer ersten Magnetfeldkomponente durch eine Induktionsschaltung (114), die auf dem Fahrzeug (101) eingerichtet ist, wobei
die Markierung (105) ein elektrischer Leiter ist, der leitend ist und das stationäre Magnetfeld oder das quasistationäre Magnetfeld emittiert, indem er eine zweite Magnetfeldkomponente in Reaktion auf die erste Magnetfeldkomponente induziert.

## Revendications

1. Système de commande de conduite autonome (102) pour un véhicule (101) qui se déplace sur une route pourvue d'un repère (105) qui émet un champ magnétique stationnaire ou un champ magnétique quasi stationnaire, le système de commande de conduite autonome (102) comprenant :
un réseau de capteurs magnétiques (104) qui est équipé sur le véhicule (101) et est adapté pour détecter le magnétisme ;
le repère (105) prévu sur la route ; et
un circuit d'induction (114) qui est équipé sur le véhicule (101) et est adapté pour induire une première composante de champ magnétique, **caractérisé en ce qu'** il comprend en outre :
un circuit de traitement d'informations (103) qui est adapté pour générer une image montrant un champ magnétique dans une région plus proche du repère (105) que le réseau de capteurs magnétiques (104), selon un résultat de détection du magnétisme et une équation fondamentale du champ magnétique stationnaire et du champ magnétique quasi stationnaire, et est adapté pour commander le déplacement du véhicule (101) selon l'image ; et
**en ce que**
le repère (105) est un conducteur électrique qui est conducteur et est adapté pour émettre le champ magnétique stationnaire ou le champ magnétique quasi stationnaire en induisant une seconde composante de champ magnétique en réponse à la première composante de champ magnétique.

2. Système de commande de conduite autonome (102) selon la revendication 1, dans lequel
le circuit de traitement d'informations (103) :
est adapté pour obtenir une vitesse du véhicule (101) ;
est adapté pour convertir des variations temporelles du résultat de détection en variations spatiales selon la vitesse ; et
est adapté pour générer l'image selon l'équation fondamentale et le résultat de détection dans lequel les variations temporelles ont été converties en variations spatiales.

3. Système de commande de conduite autonome (102) selon la revendication 1 ou 2, dans lequel
le réseau de capteurs magnétiques (104) comprend un ou plusieurs réseaux bidimensionnels de capteurs magnétiques disposés dans une direction avant-arrière et une direction gauche-droite du véhicule (101).

4. Système de commande de conduite autonome (102) selon la revendication 1 ou 2, dans lequel
le réseau de capteurs magnétiques (104) comprend un ou plusieurs réseaux unidimensionnels de capteurs magnétiques disposés dans une direction gauche-droite du véhicule (101).

5. Système de commande de conduite autonome (102) selon la revendication 1 ou 2, dans lequel
le réseau de capteurs magnétiques (104) est adapté pour détecter le magnétisme dans une seule couche disposée dans une direction avant-arrière et une direction gauche-droite du véhicule (101).

6. Système de commande de conduite autonome (102) selon la revendication 1 ou 2, dans lequel
le réseau de capteurs magnétiques (104) est adapté pour détecter le magnétisme dans deux couches disposées dans une direction avant-arrière et une direction gauche-droite du véhicule (101).

7. Système de commande de conduite autonome (102) selon la revendication 1 ou 2, dans lequel
le circuit de traitement d'informations (103) est adapté pour générer l'image selon l'expression arithmétique suivante qui est conforme au résultat de détection et à l'équation fondamentale : ${H}_{i} \left(x, y, z\right) = \frac{1}{{\left(2π\right)}^{2}} ∬ {e}^{{ik}_{x} x + {ik}_{y} y} \left\{f\left({k}_{x}, {k}_{y}\right){e}^{z \sqrt{{k}_{x}^{2} + {k}_{y}^{2}}}\right\} {dk}_{x} {dk}_{y}$
où *: Hᵢ*(*x,y,z*) est une composante *i* dans un champ magnétique à une position de coordonnées (*x,y,z*) ; *i* est *x, y* ou z ; z est une valeur de coordonnée dans une direction z depuis un sommet du véhicule (101) vers un bas du véhicule (101) ; x est une valeur de coordonnée dans une direction x orthogonale à la direction z ; y est une valeur de coordonnée dans une direction y orthogonale à la direction z et à la direction x ; *f*(*kₓ, k_{y}*) est une image de transformée de Fourier bidimensionnelle de *Hᵢ*(*x, y,* 0) indiquant le résultat de détection au niveau de (*x, y,* 0) qui est un plan de mesure ; *kₓ* est un nombre d'ondes par rapport à *x*, et *k_{y}* est un nombre d'ondes par rapport à *y.*

8. Système de commande de conduite autonome (102) selon la revendication 1 ou 2, dans lequel
le circuit de traitement d'informations (103) est adapté pour générer l'image selon l'expression arithmétique suivante qui est conforme au résultat de détection et à l'équation fondamentale : $\begin{matrix}{H}_{i} \left(x, y, z\right) = \\ \frac{1}{{\left(2π\right)}^{2}} ∬ {e}^{{ik}_{x} x + {ik}_{y} y} \left\{\frac{1}{2}\left(f\left({k}_{x}, {k}_{y}\right)+\frac{g \left({k}_{x}, {k}_{y}\right)}{\sqrt{{k}_{x}^{2} + {k}_{y}^{2}}}\right){e}^{z \sqrt{{k}_{x}^{2} + {k}_{y}^{2}}}+\frac{1}{2}\left(f\left({k}_{x}, {k}_{y}\right)-\frac{g \left({k}_{x}, {k}_{y}\right)}{\sqrt{{k}_{x}^{2} + {k}_{y}^{2}}}\right){e}^{- z \sqrt{{k}_{x}^{2} + {k}_{y}^{2}}}\right\} {dk}_{x} {dk}_{y}\end{matrix}$
où *: Hᵢ*(*x, y, z*) est une composante *i* dans un champ magnétique à une position de coordonnées (*x, y, z*) *; i* est *x, y* ou *z* ; *z* est une valeur de coordonnée dans une direction *z* depuis un sommet du véhicule (101) vers un bas du véhicule (101) ; *x* est une valeur de coordonnée dans une direction *x* orthogonale à la direction *z* ; *y* est une valeur de coordonnée dans une direction *y* orthogonale à la direction *z* et à la direction *x* ; *f*(*kₓ, k_{y}*) est une image de transformée de Fourier bidimensionnelle de *Hᵢ*(*x, y,* 0) indiquant le résultat de détection au niveau de (*x, y,* 0) qui est un plan de mesure ; *g*(*kₓ*, *k_{y}*) est une image de transformée de Fourier bidimensionnelle de ∂/∂z*Hᵢ*(*x, y, z*) I_{*z*=0} indiquant un gradient dans la direction *z* du résultat de détection au niveau de (*x*, *y*, 0) qui est le plan de mesure ; *kₓ* est un nombre d'ondes par rapport à *x*, et *k_{y}* est un nombre d'ondes par rapport à *y.*

9. Système de commande de conduite autonome (102) selon la revendication 1 ou 2, comprenant en outre :
au moins l'un parmi une caméra, un LiDAR (107), un radar à ondes millimétriques (108), un sonar à ultrasons, ou un récepteur GPS (109) équipé sur le véhicule (101), dans lequel
le circuit de traitement d'informations (103) est en outre adapté pour commander le déplacement du véhicule (101) selon ledit au moins un parmi la caméra, le LiDAR (107), le radar à ondes millimétriques (108), le sonar à ultrasons, ou le récepteur GPS (109).

10. Système de commande de conduite autonome (102) selon la revendication 1 ou 2, dans lequel
le repère (105) comprend une pluralité de repères prévus sur la route, et
la pluralité de repères sont adaptés pour émettre des champs magnétiques stationnaires ou des champs magnétiques quasi stationnaires avec une pluralité de motifs magnétiques pour commander le déplacement du véhicule (101).

11. Système de commande de conduite autonome (102) selon la revendication 10, dans lequel
chacun de la pluralité de motifs magnétiques est un motif magnétique concentrique.

12. Système de commande de conduite autonome (102) selon la revendication 10, dans lequel
chacun de la pluralité de motifs magnétiques est un motif magnétique de type code-barres.

13. Système de commande de conduite autonome (102) selon la revendication 10, dans lequel
chacun de la pluralité de motifs magnétiques est un motif magnétique de type code bidimensionnel.

14. Système de commande de conduite autonome (102) selon la revendication 1 ou 2, dans lequel
le repère (105) représente une séquence de code, sous la forme d'un agencement d'une pluralité de pôles magnétiques, pour commander le déplacement du véhicule (101),
la séquence de code comprend un code pour la détection d'erreurs, et
le circuit de traitement d'informations (103) :
est adapté pour lire la séquence de code selon l'image ;
est adapté pour déterminer si la séquence de code lue comprend une erreur selon le code inclus dans la séquence de code lue ; et
est adapté pour commander le déplacement du véhicule (101) conformément à la séquence de code lue à condition qu'il soit déterminé que la séquence de code lue ne comprend aucune erreur.

15. Système de commande de conduite autonome (102) selon la revendication 1 ou 2, dans lequel
le repère (105) présente une forme de fil.

16. Procédé de commande de conduite autonome pour un véhicule (101) qui se déplace sur une route pourvue d'un repère (105) qui émet un champ magnétique stationnaire ou un champ magnétique quasi stationnaire, le procédé de commande de conduite autonome comprenant :
la détection du magnétisme par un réseau de capteurs magnétiques (104) équipé sur le véhicule (101) ;
la génération d'une image montrant un champ magnétique dans une région plus proche du repère (105) que le réseau de capteurs magnétiques (104), selon un résultat de détection du magnétisme et une équation fondamentale du champ magnétique stationnaire et du champ magnétique quasi stationnaire, et la commande du déplacement du véhicule (101) selon l'image ; et
l'induction d'une première composante de champ magnétique par un circuit d'induction (114) équipé sur le véhicule (101), dans lequel
le repère (105) est un conducteur électrique qui est conducteur et émet le champ magnétique stationnaire ou le champ magnétique quasi stationnaire en induisant une seconde composante de champ magnétique en réponse à la première composante de champ magnétique.
